(19) Europäisches Patentamt

European Patent Office

Office européen des brevets

(11) EP 0 772 242 B1

(12) EUROPEAN PATENT SPECIFICATION

(45) Date of publication and mention
of the grant of the patent:
05.04.2006 Bulletin 2006/14

(51) Int Cl.:
*H01L 29/06* (2006.01)   *H01L 29/10* (2006.01)
*H01L 29/78* (2006.01)   *H01L 29/739* (2006.01)
*H01L 21/331* (2006.01)

(21) Application number: 95830454.5

(22) Date of filing: 30.10.1995

(54) **Single feature size MOS technology power device**

Leistungsbauteil in MOS-Technologie mit einer einzelnen kritischen Grösse

Dispositif de puissance en technologie MOS avec une seule dimension critique

(84) Designated Contracting States:
**DE ES FR GB IE IT NL PT SE**

(43) Date of publication of application:
**07.05.1997 Bulletin 1997/19**

(73) Proprietors:
• **STMicroelectronics S.r.l.**
**20041 Agrate Brianza (Milano) (IT)**
• **Consorzio per la Ricerca sulla**
**Microelettronica nel Mezzogiorno**
**95121 Catania (IT)**

(72) Inventors:
• **Frisina, Ferruccio**
**I-95030 Sant'Agata li Battiati (Catania) (IT)**
• **Magri', Angelo**
**I-95032 Belpasso (Catania) (IT)**
• **Ferla, Giuseppe**
**I-95126 Catania (IT)**

(74) Representative: **Mittler, Enrico et al**
**Mittler & C. s.r.l.,**
**Viale Lombardia, 20**
**20131 Milano (IT)**

(56) References cited:
**EP-A- 0 022 001**   **EP-A- 0 252 236**
**EP-A- 0 304 839**   **EP-A- 0 405 138**
**EP-A- 0 480 635**   **EP-A- 0 543 313**
**EP-A- 0 623 960**   **WO-A-94/11904**
**DE-A- 3 519 389**   **US-A- 4 345 265**
**US-A- 5 047 367**

• **PATENT ABSTRACTS OF JAPAN vol. 015 no. 442 (E-1131) ,11 November 1991 & JP-A-03 185737 (TOSHIBA CORP) 13 August 1991,**
• **PATENT ABSTRACTS OF JAPAN vol. 011 no. 231 (E-527) ,28 July 1987 & JP-A-62 047162 (MATSUSHITA ELECTRIC WORKS LTD) 28 February 1987,**
• **PATENT ABSTRACTS OF JAPAN vol. 014 no. 038 (E-878) ,24 January 1990 & JP-A-01 272163 (FUJI ELECTRIC CO LTD) 31 October 1989,**
• **PATENT ABSTRACTS OF JAPAN vol. 017 no. 039 (E-1311) ,25 January 1993 & JP-A-04 256367 (HITACHI LTD) 11 September 1992,**
• **PATENT ABSTRACTS OF JAPAN vol. 017 no. 213 (E-1356) ,26 April 1993 & JP-A-04 349660 (TOSHIBA CORP) 4 December 1992,**

**Description**

The present invention relates to a SingLe Feature Size MOS technology power device.

MOS technology power devices are composed of a plurality of elementary functional units integrated in a same semiconductor chip. Each elementary functional unit forms an elementary vertical MOSFET, and all the elementary functional units are connected in parallel; in this way, each elementary vertical MOSFET contributes for a respective fraction to the overaLL current of the power device.

A MOS technology power device chip comprises a LightLy doped semiconductor layer of a first conductivity type forming a common drain layer for aLL the elementary verticaL MOSFETs; the lightly doped layer is superimposed over a heavily doped semiconductor substrate. Each elementary functional unit comprises a body region of a second conductivity type formed in the drain layer. In the case of "cellular" power devices (the most common case), the body region of the elementary functional units has a polygonal Layout, for example square or hexagonal; for this reason, the elementary functional units are also called "elementary ceLLs". However, MOS technology power devices are also known wherein the body region of the elementary functional units is an elongated stripe.

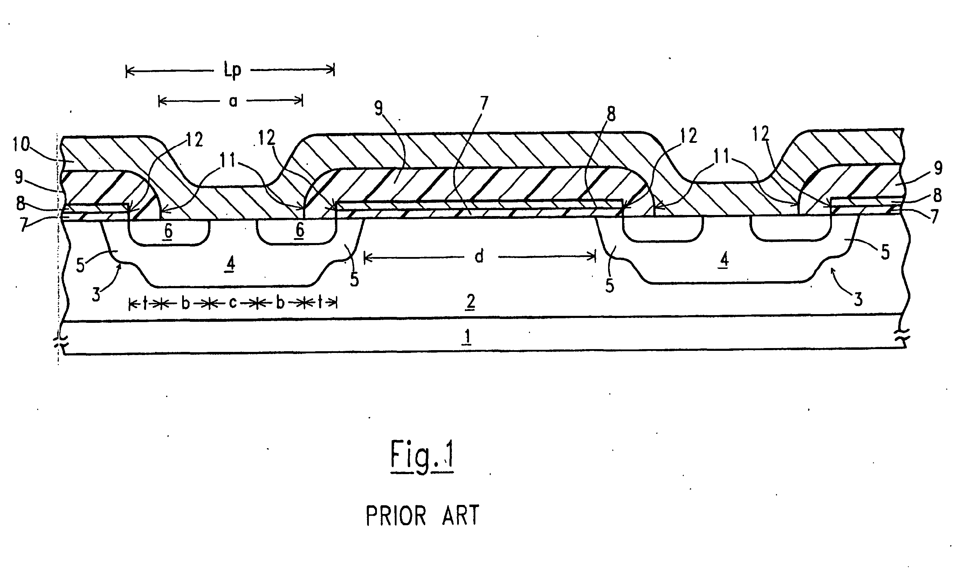

In both cases, the vertical structure of the elementary functional units (i.e. the cross-section of the cell or of the stripes) is as shown in Fig. 1, wherein the heavily doped semiconductor substrate is indicated by 1 and the common drain layer is indicated by 2. The body region 3 of the elementary functional unit comprises a central heavily doped portion 4, called "deep body region", and a lateral portion 5, having a lower dopant concentration, forming the channel region of the elementary vertical MOSFET; the doping level of the LateraL portion 5 of the body region determines the threshold voltage of the power device. Inside the body region 3, two source regions 6 of the same conductivity type as the common drain layer 2 are formed. A thin oxide layer 7 (gate oxide) and a polysilicon layer 8 (the gate electrode of the power device) cover the surface of the portions of the drain layer 2 between the body regions 3, and extend over the lateral portions 5 of the body region. The polysilicon Layer 8 is covered by a dielectric layer 9 in which contact windows 11 are opened over each body region to allow a superimposed metal layer 10 (the source electrode of the power device) to come into contact with the source regions 6 and with the deep body region 4. The short-circuit between the source regions and the body region is essential to prevent a parasitic bipolar junction transistor having emitter, base and collector formed by the source regions, the body region and the drain layer 1 from triggering on; the heavily doped deep body region 4 increases the ruggedness of the power device because it reduces the base resistance of such a parasitic transistor.

For the manufacturing of the structure described above, the following steps are required:

- formation of the drain Layer 2 over the substrate 1 (generally by means of an epitaxial growth);
- thermal growth of the thin oxide layer 7 over the whole active area of the drain layer 2 (the active area being the portion of the drain Layer wherein the elementary functional units of the MOS power device will be formed), and deposition of the poLysiLicon Layer 8;
- selective introduction of high dose of dopants to form the heavily doped deep body regions 4;
- selective etching of the poLysiLicon and oxide Layers to open windows 12 where the elementary functional units wiLL be formed;
- selective introduction of a low dose of dopants into the drain Layer through said windows to form the lightly doped portions of the body regions;
- formation of the source regions 6;
- deposition of the dielectric Layer 9 and selective etching thereof to open the contact windows 11;
- deposition and patterning of the metal Layer 10.

This process involves the use of four photolithographic masks: a first mask is used for the formation of the deep body regions 4; a second mask is used to selectively etch the polysilicon and oxide Layers; a third mask is used to form the source regions 6 (the mask for the introduction of the dopants forming the source regions is provided partially by the polysilicon and oxide Layers, and partially by photoresist isles over the middle portion of the deep body regions); a fourth mask is used to open the contact windows in the dielectric layer.

Referring again to Fig. 1, the dimension Lp of each window 12 in the polysilicon and gate oxide Layers is given by:

$$Lp \simeq a + 2t$$

where a is the dimension of the contact window 11 in the dielectric layer and t is distance between the edge of the polysilicon layer and the edge of the dielectric layer. The dimension a of the contact window is in turn:

$$a = c + 2b$$

where b is the distance between the edge of the contact window and the inner edge of the source region (i.e. the Length of the portion of source region available to be contacted by the metal layer), and c is the dimension of the middle portion of the body region wherein the source regions are absent (i.e. the distance between the inner edges of the source regions, corresponding to the Length of the portion of body region available to be contacted by the metal layer). The dimension Lp is therefore given by:

$$Lp = c + 2b + 2t$$

and the elementary functional units have a dimension determined by "three feature sizes", because their dimension depends on the three parameters c, b and t.

In MOS technology power devices, the electrical parameters to be optimized are the output resistance in the "on" condition (Ron), the gate-to-drain capacitance (feedback capacitance) and the gate-to-source capacitance (input capacitance).

The output resistance Ron is the sum of several components, each of which is associated with a particular physical region of the device. More specifically, it is:

$$Ron = Rc + Racc + Rjfet + Repy$$

where Rc (channel resistance) is the component associated with the channel region, Racc (accumulation region resistance) is the component associated with the surface region of the portion of drain layer comprised between the body regions, Rjfet is the component associated with the portion of drain Layer comprised between the depletion regions of the body regions, and Repy is the component associated with the portion of the drain Layer beneath the body regions.

The Rc component depends on process parameters such as the dopant concentration of the channel region (i.e. on the threshold voltage of the MOS power device) and on the channel Length; the Racc component depends on the distance between two adjacent body regions, and decreases as such distance decreases; the Rjfet component depends on the resistivity of the drain layer and on the distance between the body regions, and increases as such a distance decreases; the Repy component depends on the resistivity and thickness of the drain Layer, two parameters which determine the maximum voltage that can be sustained by the MOS power device.

Further, the Ron is inversely proportional to the overaLL channel perimeter of the MOS power device, i.e. to the sum of the channel perimeters of the individual elementary functional units that compose the MOS power device. The Longer the channel perimeter per unit area of the MOS power device, the Lower the Ron per unit area.

In order to reduce the Ron it is essential to scale down the dimensions of the elementary functional units and the distance (d in Fig. 1) between them, i.e. to increase the density of elementary functional units per unit area. The reduction.of the distance d between the body regions has the further advantage of lowering the input and feedback capacitances of the MOS power device, thus improving its dynamic performance. Also, it has been verified that in high-voltage MOS technology power devices reducing the distance between the body regions increases the device's ruggedness under switching condition.

In the last years, the technological trend has therefore been toward the increase of the density of elementary functional units per unit area, and nowadays MOS technology power devices with a density of up to six million elementary cells per square inch can be fabricated.

The current structure of the elementary functional units poses however some Limitations to the further reduction of the dimensions thereof. These Limitations are essentiaLLy determined by the resolution and the alignment characteristics of the photolithographic apparatus. Referring again to Fig. 1, it appears that the dimension c must be sufficiently Large to guarantee that the metal Layer contacts the body region, and can be scaled down to the resolution limit of the photolithographic apparatus; the dimension b must be sufficiently large to guarantee that the metal layer contacts the source region, and must also take into account the alignment errors between the mask defining the contact window 11 in the dielectric layer and the mask for the formation of the source regions; the dimension t must be sufficiently Large to guarantee that the poLysiLicon layer is eLectricaLLy insulated from the metal layer, and must also take into account the alignment errors between the masks for the definition of the windows in the poLysiLicon Layer and in the dielectric layer.

In addition, the current structure of the elementary functional units does not allow to reduce the distance between the elementary functional units below specified values that depend on the voltage rating of the MOS power device (approximately 5 $\mu$m for low-voltage devices and from 10 $\mu$m to 30 $\mu$m for medium and high-voltage devices). The reduction of such distance below said specified values would in fact cause a rapid increase in the Rjfet component of the Ron of the MOS power device. Documents DE-A-3519389, EP-A-0 405 138, EP-A-0 304 839, WO94/11904, EP-A-0 252 236, US-A-4 345 265, EP-A-0 543 313, EP-A-0 623 960 and EP-A-0 022 001 disclose devices of the kind of the present application.

In view of the state of the art described, it is an object of the present invention to provide a new MOS technology power device structure which allows to achieve higher scales of integration.

According to the present invention, such object is attained by means of a MOS technology power device as defined in claim 1.

In one embodiment, the body stripe includes a plurality of source portions that extend transversally inside the body stripe, and which are longitudinally intercalated with transversal body portions.

In another embodiment, the source portion can extend in the transversal direction to the middle of the body stripe, and in the longitudinal direction for substantially the whole length of the body stripe.

In a further embodiment, the body stripe can include a plurality of source portions, and each source portion can be intercalated both in the transversal direction and in the longitudinal direction with a body portion of the body stripe.

The adoption of a stripe layout for the body regions of the elementary functional units; the particular Layout of the source regions inside the body stripes, which require that the source metal layer contacts, in the direction transverval to the body stripes, just one region (either the source portion or the body portion) or at most two regions (the source portion and the body portion); and the use of sidewall spacers of insulating material to seal the edges of the elongated opening in the triple layer formed by the first insulating material layer (forming the gate insulator of the MOS power device), the conductive material layer (forming the gate of the MOS power device) and the second insulating material layer (isolating in the vertical direction the gate of the MOS power device), aLLow to shrink the transversal dimension of the elongated opening in the poLysiLicon layer, and thus to reduce the transversal dimension of the elementary functional units; this allows an increase of the density of elementary functional units per unit area.

Also according to the present invention, there is provided a process for the manufacturing of a MOS technology power device as defined in claim 22.

The step of forming said body stripe provides for selectively introducing a dopant of the second conductivity type into the semiconductor material layer using as a mask for the selective introduction only said second insulating material Layer, without the need of a dedicated mask for the formation of the heavily doped deep body region at the center of the body regions of the elementary functional units as in the conventional process. This feature, together with that previously discussed (the stripe Layout of the body regions of the elementary functional units, the particular Layout of the source regions inside the body regions, and the use of sidewall spacers of insulating material to isolate the gate layer of the MOS power device), allows to reduce the transversal dimension of the elongated opening in the triple layer comprising the first and second insulating material Layer and the first conductive material Layer to the optical resolution limit of the photolithographic apparatus in use.

These and other features and advantages of the present invention will be made more evident by the following detailed description of some particular embodiments, described as non-limiting examples in connection with the annexed drawings, wherein:

Fig. 1 is a cross-sectional view of a MOS technology power device according to the prior art;

Fig. 2 is a top-plan view of a portion of a MOS technology power device according to a first embodiment of the present invention;

Fig. 3 is a cross-sectional view along line III-III in Fig. 2;

Fig. 4 is a cross-sectional view along Line IV-IV in Fig. 2;

Figs. 5 to 12 are cross-sectional views analogous to those of Figs. 3 and 4, showing some intermediate steps of a manufacturing process of the MOS technology power device shown in fig. 2;

Fig. 13 is a top-plan view of the portion of MOS technology power device shown in Fig. 2, at an intermediate step of the manufacturing process.

Fig. 14 is a top-plan view of a portion of a MOS technology power device according to a second embodiment of the present invention;

Fig. 15 is a cross-sectional view along line XV-XV in Fig. 14;

Fig. 16 is a cross-sectional view along line XVI-XVI in Fig. 14;

Fig. 17 is a cross-sectional view along Line XVII-XVII in Fig. 14;

Fig. 18 is a top-plan view of the portion of MOS technology power device shown in Fig. 14, at an intermediate step of the manufacturing process;

Fig. 19 is a top-plan view of a portion of a MOS-technoLogy power device according to a third embodiment of the present invention;

Fig. 20 is a cross-sectional view along line XX-XX in Fig. 19;

Fig. 21 is a cross-sectional view along Line XXI-XXI in Fig. 19;

Fig. 22 is a top-plan view of the portion of MOS technology power device shown in Fig. 19, at an intermediate step of the manufacturing process;

Fig. 23 is a top-plan view of a portion of a MOS technology power device according to a fourth embodiment of the present invention;

Fig. 24 is a cross-sectional view aLong Line XXIV-XXtV in Fig. 23;

Fig. 25 is a cross-sectional view along Line XXV-XXV in Fig. 23;

Fig. 26 is a top plan view of the portion of MOS technology power device shown in Fig. 23, at an intermediate step of the manufacturing process;

Fig. 27 is a top plan view of a portion of a MOS technology power device according to a fifth embodiment of the present invention;

Fig. 28 is a cross-sectional view along line XXVIII-XXVIII in Fig. 27;

Fig. 29 is a top plan view of the portion of the MOS technology power device of Fig. 27, at an intermediate step of the manufacturing process.

Fig. 1 is a cross-sectional view of a MOS technology power device chip according to the prior art. The chip comprises a heavily doped semiconductor substrate 1, over which a LightLy doped epitaxial Layer 2 of a first conductivity type is formed. The MOS power device is composed of a plurality of elementary functional units, formed in the epitaxial Layer 2. Two of said elementary functional units are visible in Fig. 1. Each elementary functional units comprises a body region 3 of a second conductivity type formed in the epitaxial Layer 2. The body regions 3 can have a polygonal Layout (for example square or hexagonal), or can be elongated stripes (in this case, Fig. 1 is a cross-section in a direction transversal to the stripes). The body region 3 of the elementary functional unit comprises a central heavily doped portion 4, called "deep body region", and a lateral portion 5, having a lower dopant concentration, forming a channel region; the doping leveL of the lateral portion 5 of the body region determines the threshold voltage of the power device. Inside the body region 3, two source regions 6 of the same conductivity type as the epitaxial Layer 2 are formed. A thin oxide Layer 7 (gate oxide) and a poLysiLicon Layer 8 cover the surface of the portions of the epitaxial Layer 2 between the body regions 3, and extend over the lateral portions 5 of the body regions 3. Windows 12 are provided in the poLysiLicon and gate oxide Layers 8, 7 over the body regions 3. The poLysiLicon Layer 8 is covered by a dielectric Layer 9 in which contact windows 11 are opened over each body region 3, to allow a superimposed metal layer 10 (the source electrode of the power device) to come into contact with the source regions 6 and the deep body regions 4.

The size of an elementary functional unit of the MOS power device substantially corresponds to the dimension Lp of the window 12 in the polysilicon and gate oxide Layers 8 and 7. As visible, such a dimension is:

$$Lp = a + 2t$$

where a is the dimension of the contact window 11 in the dielectric Layer 9 and t is distance between the edge of the poLysiLicon Layer and the edge of the dielectric Layer. The dimension a of the contact window is, in turn:

$$a = c + 2b$$

where b is the distance between the edge of the contact window 11 and the inner edge of the source region 6 (i.e. the Length of the portion of source region available to be contacted by the source metal Layer 10), and c is the dimension of the middle portion of the body region wherein the source regions 6 are absent (i.e. the distance between the inner edges of the source regions 6, corresponding to the length of the portion of the body region 3 avaiLabLe to be contacted by the source metal layer 10). The dimension Lp is therefore:

$$Lp = c + 2b + 2t.$$

The dimension of the elementary functional units is therefore determined by the three feature sizes c, b and t.

In the following description, the same numerals used in Fig. 1 will be adopted to indicate similar parts.

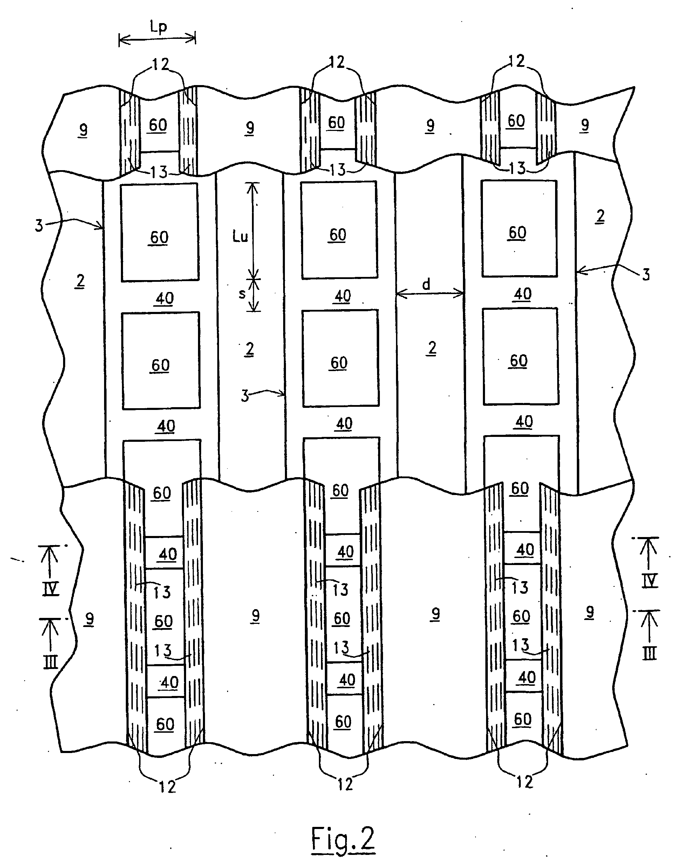

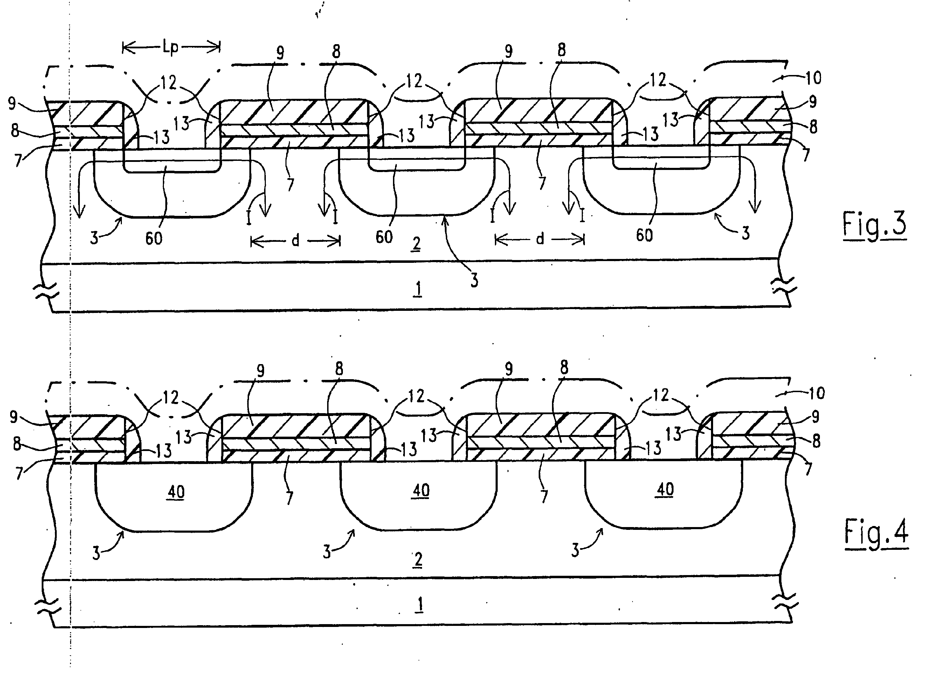

Fig. 2 is a top-plan view of a portion of a MOS technology power device according to a first embodiment of the present invention. As visible in conjunction with the cross-sectional views of Figs. 3 and 4, the MOS power device comprises a lightly doped semiconductor layer 2 of a first conductivity type, typically an epitaxial layer, superimposed over a heavily doped semiconductor substrate 1; the epitaxial layer 2 forms a common drain layer of the MOS power device, and can be either of the N conductivity type for an N channel device, or of the P conductivity type for a P channel device. In the case of a power MOSFET the substrate 1 is of the same conductivity type as the epitaxial layer 2, while in the case of an InsuLated Gate BipoLar Transistor (IGBT) the substrate T and the epitaxial Layer 2 are of opposite conductivity types.

The MOS power device comprises a plurality of elementary functional units formed in the epitaxial layer 2. Each elementary functional unit comprises a body region 3 of the opposite conductivity type of the epitaxial layer 2; as visible in Fig. 2, the body regions 3 have the form of substantially parallel elongated stripes spaced apart of a distance d from each other.

Inside each body stripe 3, a plurality of heavily doped regions 60 of the opposite conductivity type of the body stripe 3 are provided; the regions 60 extend in the longitudinal direction of the body stripe 3, and are intercalated with transversal portions 40 of the body stripe 3. The regions 60 form source regions of the MOS power device.

The surface of the drain layer 2 is covered by a triple layer comprising an insulating layer 7, a conductive layer 8 and a passivation Layer 9. The insulating layer 7 is typically a thin silicon dioxide Layer, and forms the gate oxide of the elementary functional units. The conductive layer 8 is tipically a polysilicon layer; the polysilicon Layer 8 forms the gate electrode of the MOS power device; to reduce the gate resistance of the MOS power device, the polysilicon layer 8 can be doped with phosphor or arsenic, or alternatively a silicide layer (for example cobalt silicide) can be provided over the polysilicon layer 8. The passivation layer 9 provides the upper isolation of the polysilicon layer 8.

The triple layer formed by the gate oxide layer 7, the polysilicon layer 8 and the passivation layer 9 covers the surface of the epitaxial layer 2 between the body stripes 3, and extends partially over the stripes 3 to the edges of the regions 60. Elongated openings 12 with substantially vertical walls are provided in said triple layer over the central portion of the body stripes 3, to allow a metal layer 10 (shown in dash-and-dot lines in Figs. 3 and 4) forming the source electrode of the MOS power device to contact both the source regions 60 and the transversal portions 40 of the body stripes 3. Sidewall spacers 13 of insulating material (typically silicon dioxide) seaL the vertical edges of the openings 12 in the above mentioned triple layer, to laterally isolate the polysilicon layer 8 from the metal layer 10.

A process for the manufacturing of a MOS technology power device according to the present invention initially provides for epitaxially growing a lightly doped semiconductor layer 2 over a heavily doped semiconductor substrate 1. As previously mentioned, if the power device to be formed is a power MOSFET, the substrate 1 and the epitaxial layer 2 are of the same conductivity type; if differently an Insulated Gate Bipolar Transistor (IGBT) is to be fabricated, the substrate 1 and the epitaxial Layer 2 are of opposite conductivity types. The resistivity and the thickness of the epitaxial Layer 2 depend on the voltage class of the power device (low-voltage or high-voltage), and usually range from 0.5 Ohm cm to 100 Ohm cm, and from 3 $\mu$m to 100 $\mu$m, respectively.

A thin silicon dioxide layer 7 (gate oxide) is formed over the surface of the epitaxial layer 2, usually by means of a thermal oxidation process.

A polysilicon layer 8 is then formed over the gate oxide layer 7. The polysilicon layer is then doped to reduce its resistivity. In alternative, or in addition to this, a layer of silicide (for example cobalt silicide) can be formed over the polysilicon layer 8 by depositing over the surface of the polysilicon layer 8 a layer of cobalt, and by performing a thermal process. The silicide layer greatly reduce the gate resistance of the MOS power device.

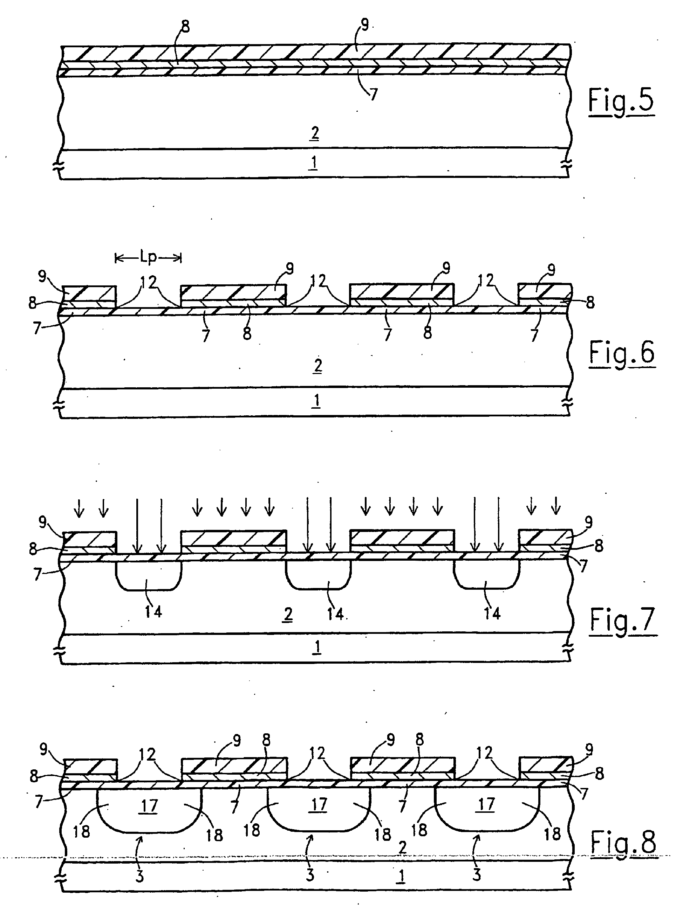

A passivation layer 9 (for example an oxide layer formed by means of a chemical vapor deposition and doped with Ptype dopants, Knownas PVAPOX) is then formed over the polysilicon layer (Fig. 5).

A photoresist layer is then deposited over the passivation layer 9, and the chip is selectively exposed by mean of a photolithographic mask to a light source. The photoresist layer is then selectively removed from regions of the passivation layer 9 which are to be etched away. The passivation layer 9, and the polysilicon layer 8 are then etched away to form elongated openings 12 with substantially vertical walls (Fig. 6); the regions of the passivation layer 9 that are still covered by the photoresist layer are not subject to the etching.

Body stripes 3 of the second conductivity type are then formed in the epitaxial Layer 2 under said elongated openings 12.

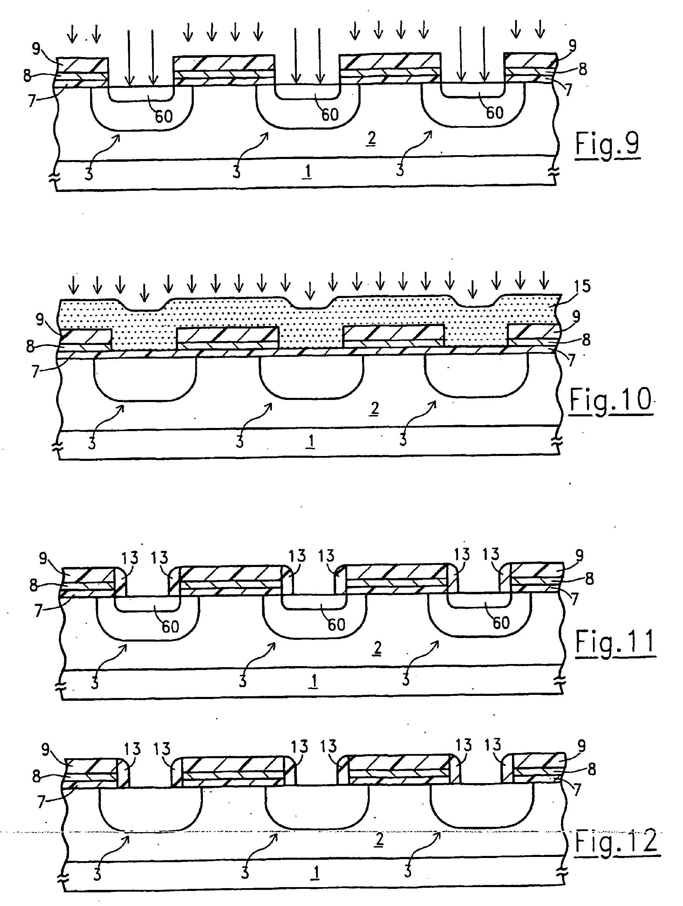

A heavy dose of a dopant of the second conductivity type is implanted at high energy into the epitaxial layer 2, the passivation layer 9 (and the underlying polysilicon layer 8) acting as an implant mask for the dopant ions (Fig. 7). For example, boron ions can be implanted in a dose of $10^{14}$-$10^{15}$ cm$^{-2}$ at an energy of 100-300 keV. Due to the high implantation energy, regions 14 of the second conductivity type are obtained in the epitaxial layer 2 wherein the distribution of implanted ions has a peak located at a prescribed distance from the surface of the epitaxial layer 2; the actual value of said distance depends on the implantation energy, the implantation energy is such as to locate the peak concentration of dopants under the source regions which will be formed in a Later step; in addition, said regions 14 are laterally aligned with the edges of the elongated openings 12. The implanted ions are then made to diffuse by means of a thermal process to form body stripes 3 (Fig. 8). Said thermal process has a temperature and a time duration chosen in such a way as the body stripes 3 comprise a central heavily doped deep body stripe 17, formed by vertical diffusion of the dopants and aligned with the edges of the elongated openings 12, and two lateral lightly doped channel stripes 18 laterally extending under the gate oxide layer 7, formed by lateral diffusion of the dopants. A suitable thermal process can be for example 1050-1100 °C for 0.5-2 hours.

As an alternative, the body stripes 3 can be formed by means of two distinct implants of dopants of the second conductivity type, in different doses and at different energies, with the passivation layer 9 (and the underlying polysilicon layer 8) acting again as an implantation mask for both the implants. For example, the first implant can involve a dose of dopants in the range $10^{13}$-$10^{14}$ atoms/cm$^{-2}$ with an energy of approximately 80 keV and is used to control the dopant concentration at the surface of the body stripes, exspecially in the channel portions, to set the desired threshold voltage of the MOS power device. The second implant involves for example a dose of dopant in the range $10^{14}$-$10^{15}$ atoms/cm$^2$ with an energy comprised between 100 keV and 300 keV, such that the peak concentration of the dopants can be located at a prescribed depth, namely under the source regions which will be formed in a later step. A subsequent thermal diffusion process at a temperature in the range 1050-1100 °C for 0.5 to 2 hours determines the lateral diffusion of the dopant introduced with the first implant, to form the channel portions of the body stripes extending under the gate oxide layer; the vertical diffusion of the dopant introduced with the second implant does not alter the threshold voltage of the MOS power device because the dopant ions reach the surface with a concentration Lower than the concentration of the dopant introduced with the first implant (in fact, the peak dopant concentration of the dopant introduced with the first implant is Located substantially at the surface of the drain layer 2). The vertical and lateral diffusion of the dopants introduced with the second implant forms the heavily doped deep body portions of the body stripes, reducing the resistivity of the body stripes under the source regions.

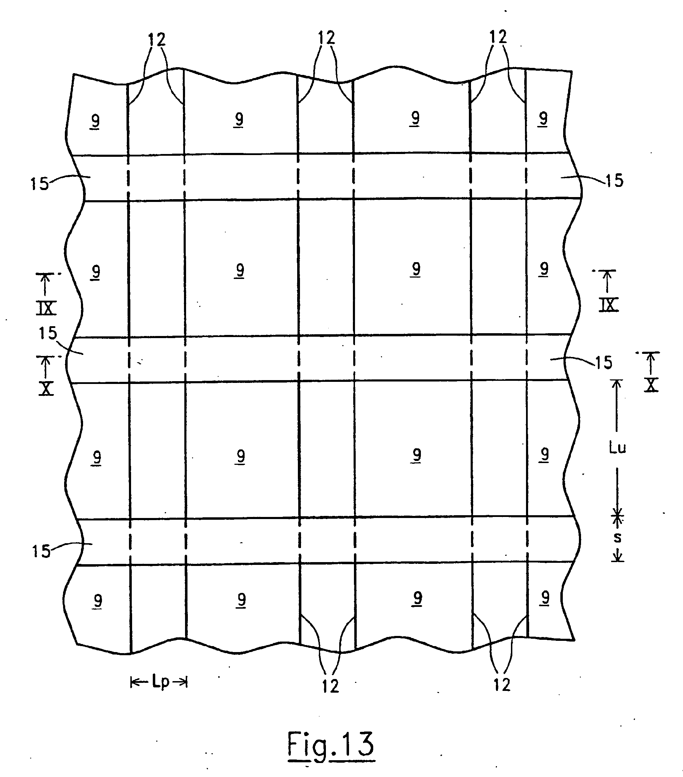

After the body stripes 3 have been formed, dopants of the first conductivity type are selectively introduced in the body stripes 3 in a heavy dose to form the source regions of the power device. This step involves the deposition of a photoresist layer 15 (Figs. 10 and 13) over the surface of the chip, and the selective exposition of the chip to a Light source by means of a photolithographic mask; the pattern of the photolithographic mask is thus transferred to the photoresist layer 15. The photoresist layer 15 is then selectively removed from the surface of the chip, to obtain the pattern shown in Fig. 13. In the regions where the photoresist layer is removed, also the gate oxide layer 7 is removed. The photoresist layer 15, together with the passivation Layer 9, acts as an implantation mask for dopants of the first conductivity type; in this way, source regions 60 are formed which are intercalated in the LongitudinaL direction of the body stripes 3 with transversaL portions 40 of the body stripes (Figs. 9 and 10).

It is to be noted that a misalignment between the photolithographic mask used for defining the pattern of the photoresist layer 15 and the photolithographic mask used for defining the elongated openings 12 in both the longitudinal and transversal directions does not have any effect on the final structure, because even in case of an alignment error there will always be source regions 60 intercalated, in the Longitudinal direction of the body stripes 3, with transversal portions 40 of the body stripes.

The photoresist layer 15, and the underlying portions of the gate oxide layer 7 are then removed. Oxide sidewall spacers 13 are then formed along the edges of the elongated openings 12 in the passivation, poLysiLicon and gate oxide Layers; the passivation layer 9 and the sidewall spacers 13 electrically isolate the polysilicon layer 8. A metal layer (10 in Figs. 3 and 4) is then deposited over the passivation layer 9 and it is selectively removed to define a source electrode of the power device.

Differently from the prior art structures, wherein the dimension of the elementary functional units (cells or stripes) is determined by three feature sizes (Lp= c+2b+2t), in the structure of the present invention the transversal dimension of the elementary functional unit is determined by one feature size only.

The reduction of the number of feature sizes determining the dimension Lp from three to one is the consequence of three circumstances, as will be now described in detail.

First, as previously described in connection with Fig. 1, in the prior art structures the insulation of the polysilicon layer from the source metal layer is achieved by means of a dielectric layer in which contact windows are opened by means of a photolithographic mask distinct from the mask used for defining the windows in the polysilicon Layer. One feature size determining the dimension Lp of the windows in the polysilicon layer is therefore the distance t (Fig. 1) between the edge of the window in the polysilicon layer and the edge of the contact window, distance that must be sufficiently large to guarantee the electrical insulation of the polysilicon layer from the source metal layer (the corners of the contact windows are the critical regions), taking into account the alignment tolerance between the two photolithographic masks. Differently, in the structure of the present invention the insulation of the polysilicon layer 8 from the source metal layer 10 is achieved vertically by means of the passivation layer 9 (etched simultaneously with the polysilicon layer to form the elongated openings 12), and laterally by means of the sidewall spacers 13 of insulating material sealing the vertical edges of the elongated openings 12. The mask for opening the contact windows in the dielectric Layer is eliminated, and there is no need to guarantee the distance t between the edge of the window in the poLysiLicon Layer and the edge of the contact window. The feature sizes determining the dimension Lp are reduced by one.

Second, thanks to the particular layout of the elementary functional units comprising elongated body stripes with source regions 60 intercalated in the longitudinal direction with transversal portions 40 of the body stripe, the contact of the source metal Layer 10 to both the source regions and to the body stripes is always guaranteed. This eliminates the problems associated with the prior art structure shown in Fig. 1, wherein it is necessary to guarantee the distance b between the edge of the contact window in the dielectric Layer and the inner edge of the source regions.

Third, the particular way in which the deep body stripes are formed eliminates the need for a dedicated mask for the formation of the deep body region, mask that in the prior art must be internal to the openings 12 in the polysilicon Layer, to avoid that the lateral diffusion of the dopants alters the dopant concentration in the channel regions.

Thanks to the structure of the present invention, the transversal dimension Lp of the elongated openings 12 in the triple layer comprising the gate oxide layer 7, the polysilicon layer 8 and the passivation layer 9 (Figs. 2 and 3) can be scaled down to the optical resolution limit f of the photolithographic apparatus used to define said openings 12. By comparison, while in the prior art structures the minimum value of Lp is Lp=f+2b+2t, approximately equal to 38 (Fig. 1), because the dimension of the elementary functional unit is determined by three feature sizes, in the structure according to the present invention the minimum value of Lp is Lp=f.

Supposing that the photolithographic apparatus used to fabricate the MOS power device is of the type involving the exposition of the entire chip at a time, it is possible to shrink the dimension Lp from approximateLy 8 $\mu$m, achievable with the prior art structures and corresponding to an equivalent density of elementary cells of 3.5 millions cells per square inch, to about 2.6 $\mu$m, that corresponds to an equivalent density of elementary cells of about 10 millions cells per square inch. If instead the photolithographic apparatus is of the stepper type, involving the exposition of only a portion of the chip at a time, a further reduction of Lp to approximately 1 $\mu$m or Less is possible, corresponding to an equivalent density of elementary cells of about 30 millions cells per square inch.

Referring to Fig. 2, it can be appreciated that the channel perimeter is proportional to the ratio

$$Lu/(Lu + s)$$

where Lu is the Length of a source region 60 in the Longitudinal direction of the body stripe 3, and s is the distance between two consecutive source regions 60 (s is the dimension of the transversal portions 40 of the body stripes wherein the source regions are absent, and the transversal portions 40 of the body stripes 3 are functionally inactive areas from the point of view of the current conduction). Since as previously mentioned the "on" resistance Ron of the MOS power device is inversely proportional to the overaLL channel perimeter of the power device, it appears that the best result for Ron is achieved by making s as smaLL as possible and Lu as large as possible. The minimum value for s is given by the optical resolution limit f of the photolithographic apparatus, while the maximum value for Lu depends on the particular technology and voltage rating of the MOS power device. In fact, the higher the distance Lu between two consecutive contacts to the body stripe 3, the higher the base resistance of the parasitic bipolar junction transistor that is intrinsicaLLy associated with the structure formed by the source regions 60, the body stripe 3 and the epitaxial Layer 2, and the lower the maximum current that the MOS power device can withstand during switching; as a consequence, the MOS power device cannot sustain the maximum specified voltage.

In this first embodiment of the present invention, the source regions 60 in adjacent body stripes 3 are aligned in the transversal direction of the body stripes, i.e. the source regions 60 in adjacent body stripes 3 are one in front of the other. This means that in the portions of the epitaxial layer 2 comprised between adjacent body stripes 3 there are two current fluxes I (Fig. 3), coming from the facing source regions 60 in the adjacent body stripes 3. The distance d between adjacent body stripes 3 cannot therefore be reduced too much.

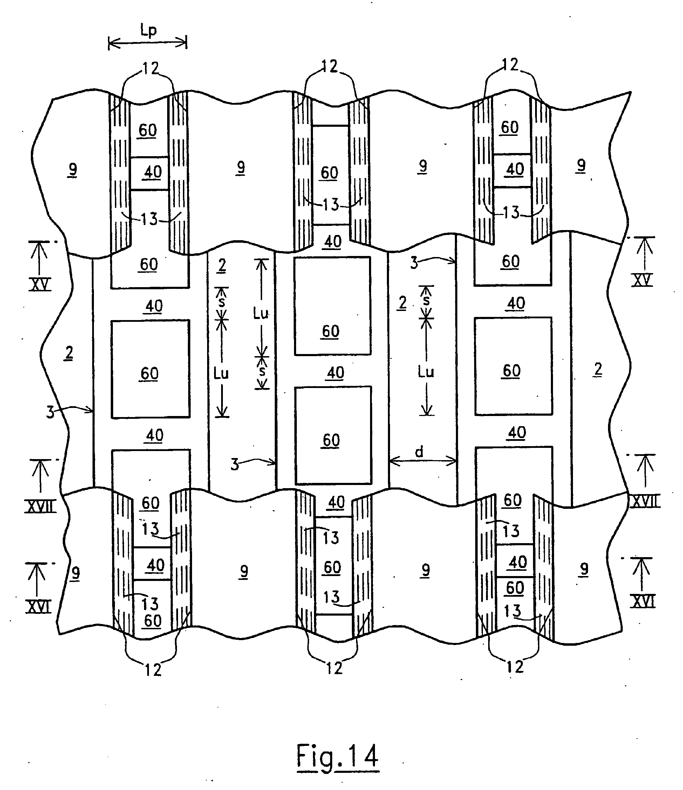

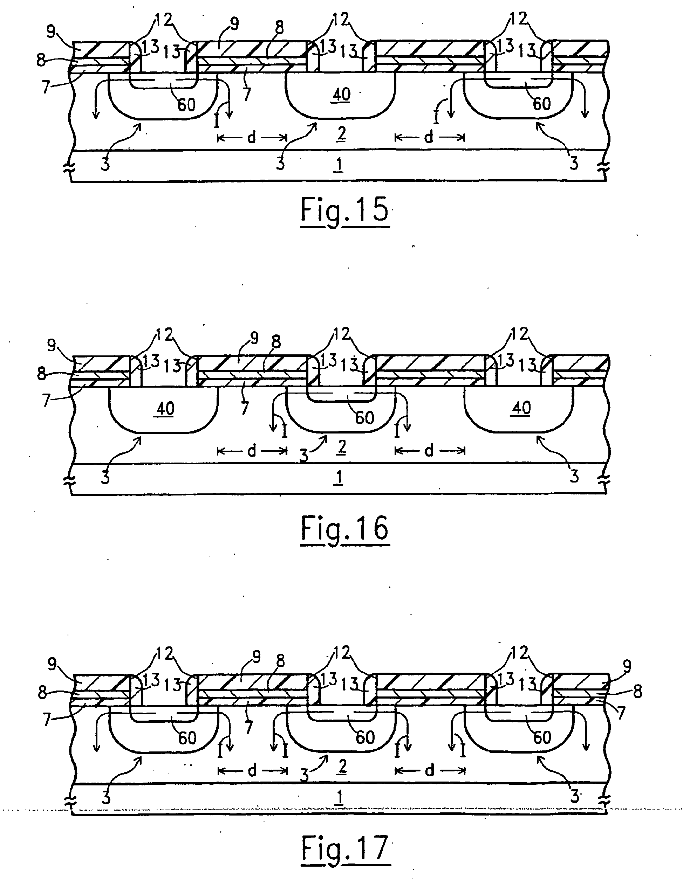

Fig. 14 is a top-plan view of a portion of a MOS power device according to a second embodiment of the present invention. This embodiment is substantially similar to that of Fig. 2, the only difference residing in the fact that the source regions 60 in a given body stripe 3 are shifted in the Longitudinal direction with respect to the source regions 60 in the adjacent body stripes 3. In this way, as visible in the cross-sectional views of Figs.15, 16 and 17, there are portions of the epitaxial Layer 2 between adjacent body stripes 3 wherein there is only one current flux I coming either from the source regions 60 of one body stripe 3 or from the source regions 60 of the adjacent body stripe 3; these portions of the epitaxial Layer 2 have a longitudinal dimension equal to s.

Thanks to this arrangement, it is possible to sLightLy reduce the distance d between the body stripes 3 without increasing the Rjfet component of the Ron; the increased integration density allows an increase of the overall channel perimeter per unit area. However, since to maximize the channel perimeter the dimension s should be small compared with the dimension Lu, the admissible reduction in the distance d is also small, because the portions of the epitaxial layer 2 between the body stripes 3 are mainly interested by the flow of two current fluxes I (Fig. 17).

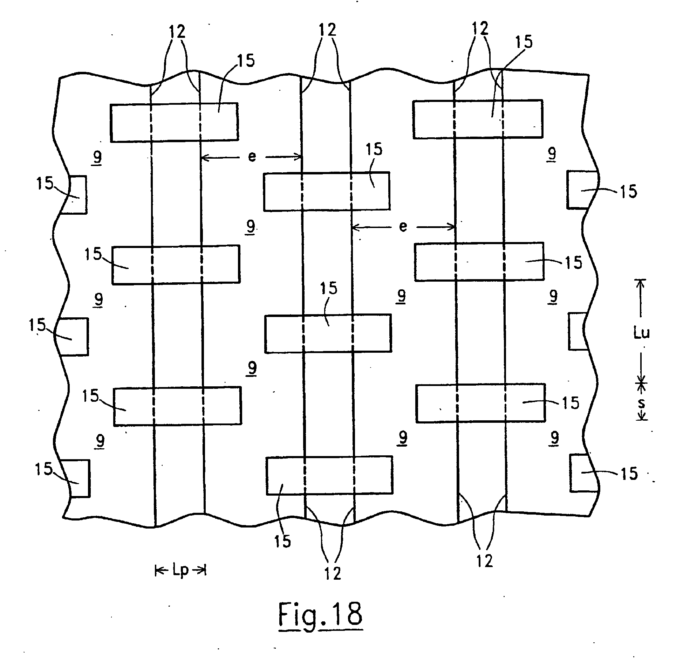

The MOS power device according to this second embodiment can be fabricated by means of the same manufacturing process previously described. The only difference is in the layout of the photolithographic mask used in the step of formation of the source regions, which originates the pattern of photoresist 15 shown in Fig. 18. To take into account the alignment tolerances of the photolithographic apparatus, the distance e between adjacent elongated openings 12 in the polysilicon and passivation Layers 8 and 9 must be larger than twice the alignment tolerance Lt of the photolithographic apparatus, to prevent that a misalignment in the transversal direction between the mask for defining the pattern in the photoresist layer 15 and the mask for the definition of the elongated openings 12 gives rise to an incorrect Layout. However, this is not a major Limitation, because the alignment tolerance of a photolithographic apparatus is normally smaller (approximately 1/3 or 1/4) than its optical resolution limit f, and the dimension e is normally larger than the optical resolution limit f of the photolithographic apparatus. For example, using a stepper photolithographic apparatus with an optical resolution limit f approximately equal to 1 $\mu$m, the alignment tolerance Lt is approximately 0.3 $\mu$m.

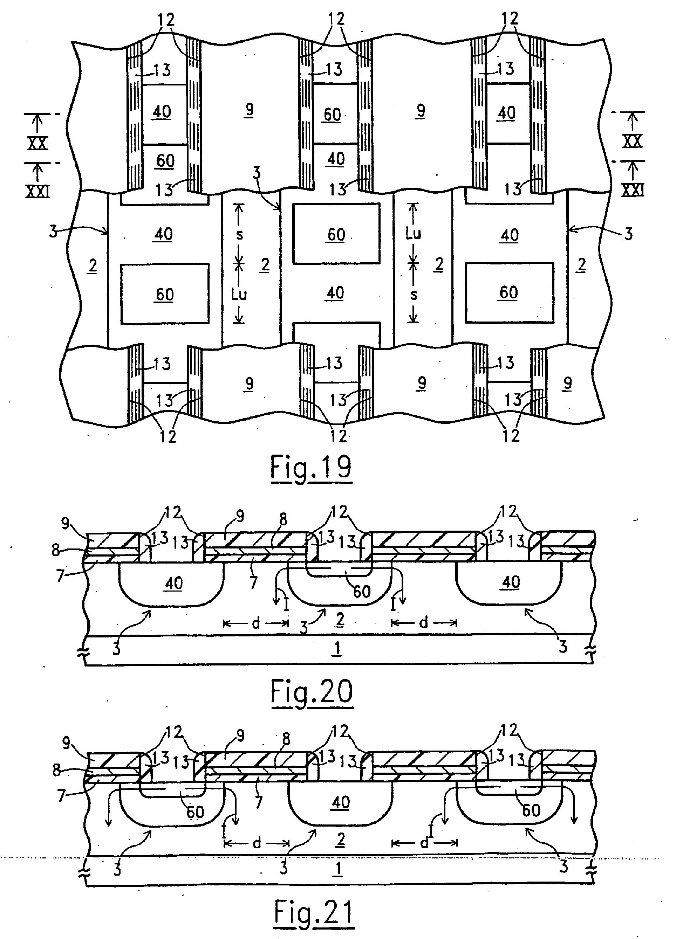

Fig. 19 is a top-plan view of a portion of a MOS technology power device according to a third embodiment of the invention, which is substantially a variant of the embodiment of Fig. 14 in that the length s of the transversal portions 40 of the body stripes 3 wherein the source regions 60 are absent is the same as the length Lu of the source regions 60. The channel perimeter for a single elementary functional unit (body stripe) is approximately a half of that achievable with the structures of the previous two embodiments, but this embodiment has the advantage that, with respect to the structure of Fig. 2, the distance d between adjacent body stripes 3 can be reduced to a half, because the source regions 60 of a given body stripe 3 always faces the transversal portions 40 of the adjacent body stripes 3; thanks to this, as visible in Figs. 20 and 21, the portions of the epitaxial layer 2 comprised between the body stripes 3 are always interested by a current flux I coming from only one side. The reduction of the distance between the body stripes 3 Leads to a lowering of the feedback capacitance of the MOS power device, because the area of superposition between the polysilicon layer and the drain Layer is reduced. This is of great benefit for the dynamic performance of the device. It is worth noting that the reduction of the distance d between adjacent elementary functional units allows a great increase of the integration density, and the overall channel perimeter per unit area can be higher than that achievable with structures of the previous two embodiments.

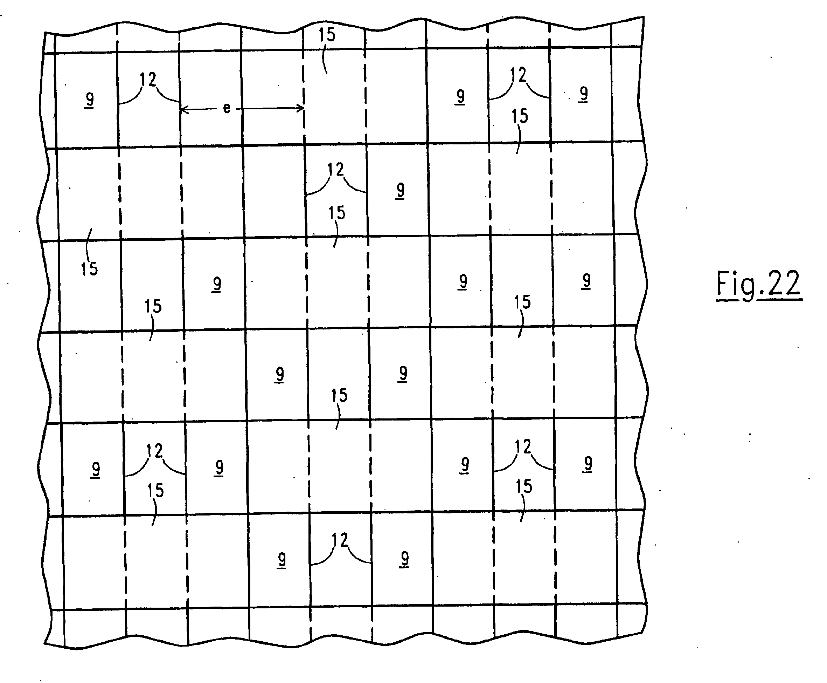

The MOS power device according to this third embodiment can be fabricated by means of the same manufacturing process previously described. The only difference is in the Layout of the photolithographic mask used in the step of formation of the source regions, which originates the pattern of photoresist 15 shown in Fig. 22. As in the case the embodiment of Fig. 14, the distance e between adjacent elongated openings 12 in the passivation and polysilicon Layers must be greater than twice the alignment tolerance Lt of the photolithographic apparatus in use, to take into account the possible alignment errors between the masks. Again, this is not a major Limitation, because as already mentioned Lt is approximately 1/4 of the optical resolution limit, and even if this embodiment allows a significant reduction of the distance d between adjacent body stripes 3, the dimension e is larger than the optical resolution limit of the photolithographic apparatus.

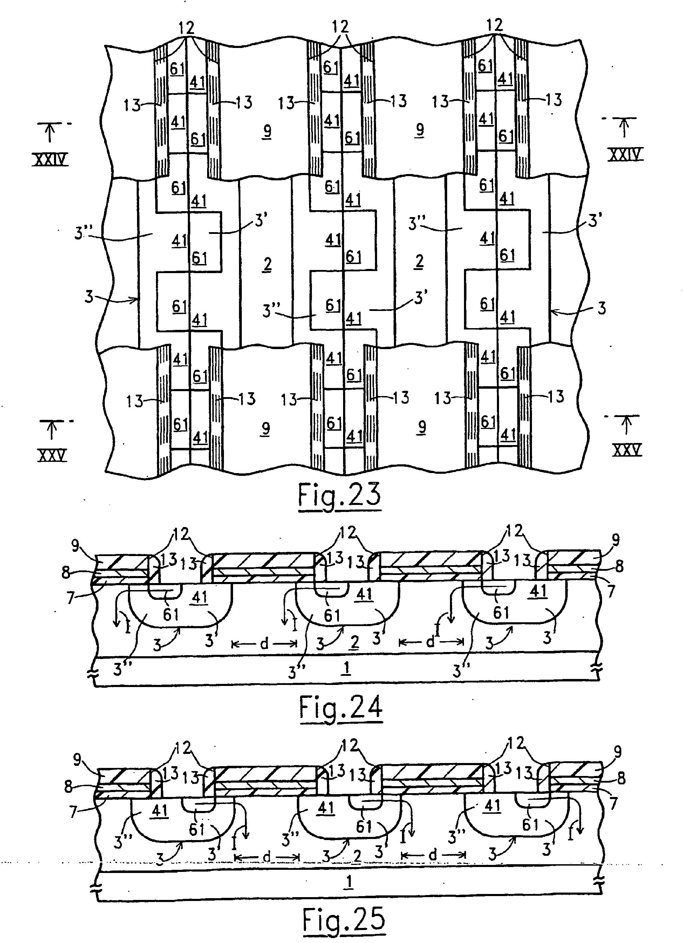

Fig. 23 is a top-plan view of a portion of a MOS power device according to a fourth embodiment of the invention. In this embodiment, each body stripe 3 is ideally divided into two LongitudinaL half-stripes 3' and 3", and in each half-stripe source regions 61 of the opposite conductivity type of the body stripe 3 are intercalated in the longitudinal, direction with body portions 41 of the half-stripe wherein the source regions are absent. In addition, the source regions 61 in one half-stripe are contiguous to the body portions 41 of the other half-stripe, and face the body portions 41 of the adjacent body stripe 3.

As in the case of the structure of Fig. 19, this arrangement makes it possible to reduce the distance d between adjacent body stripes, because the portions of the epitaxial Layer 2 comprised between adjacent body stripes 3 are always interested by a current flux I from only one side (Figs. 24 and 25).

An advantage of this embodiment with respect to the previous three is that it allows the source metal layer (not shown) to contact the body stripes 3 and the source regions 61 along their whole length, instead of at regularly spaced intervals of Length equal to Lu; this increases the ruggedness of the MOS power device, because the base-emitter resistance of the parasitic bipolar junction transistor associated with the structure formed by the source regions, the body stripes and the epitaxial layer is minimized.

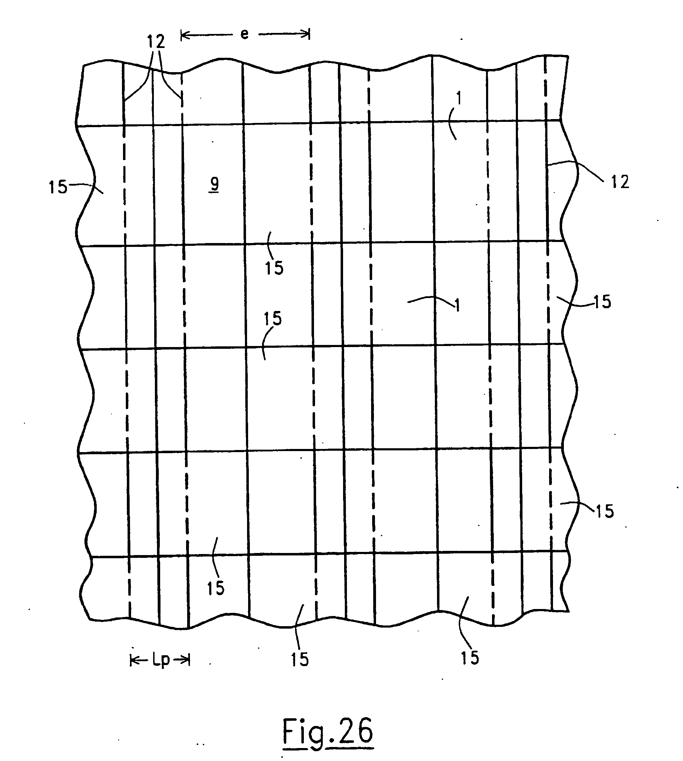

ALso this fourth embodiment of MOS technology power device can be fabricated by means of the manufacturing process previously described, the only difference is in the layout of the mask used to form the source regions (source mask), which originates the pattern of photoresist 15 shown in Fig. 26. It can be appreciated that the Layout of the source mask is substantially the same as that of Fig. 22, the only difference being the different alignment of the source mask with respect to the mask for defining the elongated openings 12 in the passivation and poLysiLicon Layers. In this case not only it is necessary that the distance e between adjacent elongated openings 12 is greater than twice the alignment tolerance Lt of the photolithographic apparatus in use, but also the dimension Lp of the elongated openings must be greater than 2Lt, to prevent that alignment errors between the masks causes an incorrect layout. However, since the minimum value for dimension Lp is the optical resolution limit of the photolithographic apparatus, and since the alignment tolerance Lt is approximately 1/4 the optical resolution Limit, the necessity to take into account the possible alignment errors between the masks does not poses Limits to the shrinking of the size of the elementary functional units: the contact of the source metal layer (not shown) to the source regions 61 and to the body portions 41 is guaranteed even if the dimension Lp of the elongated openings 12 is reduced to the optical resolution limit of the photolithographic apparatus.

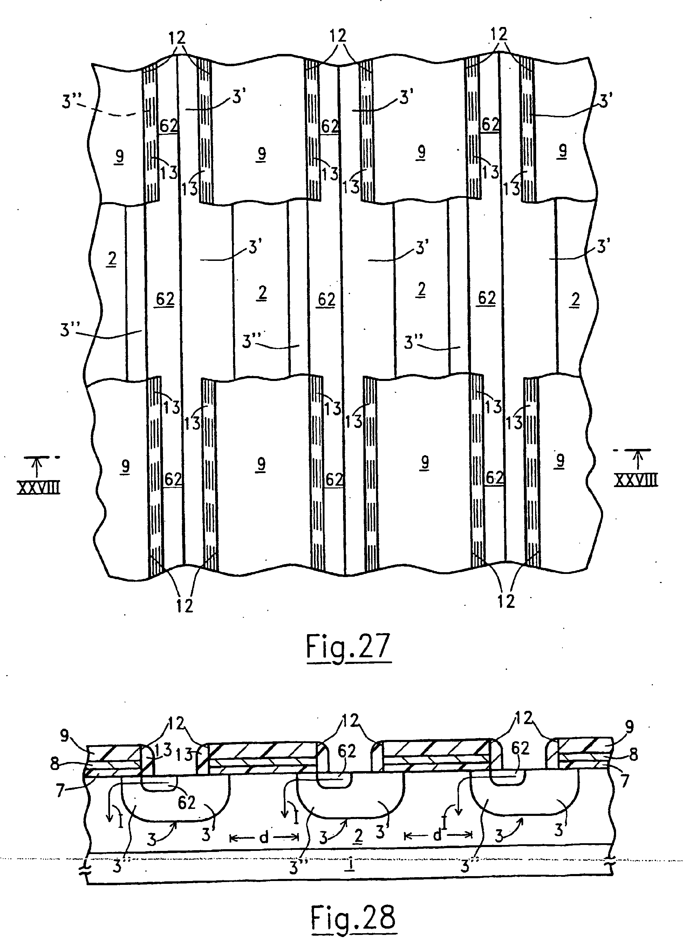

Fig. 27 is a top-plan view of a MOS power device according to a further embodiment of the present invention. As in the case of Fig. 23, each body stripe 3 is idellay divided in two half-stripes 3' and 3"; in one (3") of the two half-stripes 3', 3", a source region 62 is provided that extends substantially for the whole Length of the body stripe 3, while in the other half-stripe (3'), no source region is provided at all. As with the arrangement of Fig. 23, it is possible to reduce the distance d between adjacent body stripes, because in the portions of the drain Layer 2 comprised between adjacent body stripes there is a current flux I coming from only one side (Fig. 28). In addition, as the fourth embodiment, this embodiment increases the ruggedness of the MOS power device, because the body stripe 3 and the source region 62 are contacted by the source metal Layer along their whole Length.

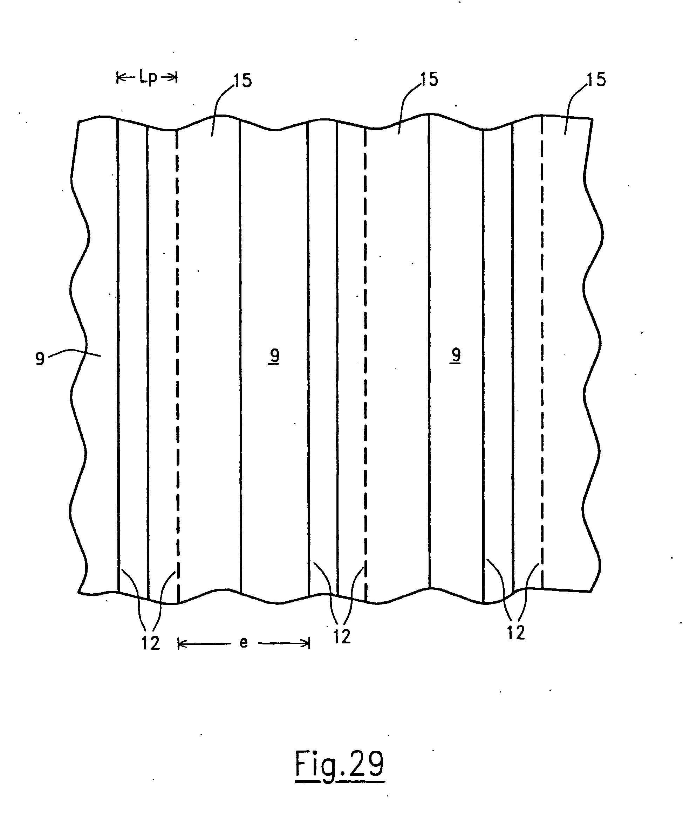

Also this fifth embodiment of the invention can be fabricated by means of the same manufacturing process previously described. The only difference is the Layout of the source mask, which originates the pattern of photoresist 15 shown in Fig. 29. As in the case of the fourth embodiment, both the distance e between adjacent opening in the passivation and poLysiLicon Layers 9 and 8, and the dimension Lp of the elongated openings 12 must be at Least twice the alignment tolerance Lt of the photolithographic apparatus in use, to prevent Layout errors due to the alignment errors between the source mask and the mask for defining the elongated openings 12.

Both the embodiments of Figs. 23 and 27 are better from the point of view of the ruggedness of the MOS power device, but are more critical than the first three embodiments from the point of view of the alignment of the source mask with the mask for defining the elongated openings 12 in the passivation and polysilicon layer 9 and 8: the source mask must in fact be aligned within the dimension Lp of the elongated opening 12, which means that the dimension Lp must guarantee the simultaneous contact to two different regions (in other words, the dimension Lp must be larger than twice the alignement tolerance Lt of the photolithographic apparatus). However, as already mentioned, the necessity to respect this alignment between the masks does not prevent the possibility to shrink the dimension Lp of the elongated opening 12 to the optical resolution limit of the photolithographic apparatus, since the alignment tolerance Lt is always significantly smaller than the optical resolution limit.

## Claims

1.  MOS technology power device comprising:

    a semiconductor layer (2) of a first conductivity type;
    a conductive insulated gate layer (7, 8, 9) covering the semiconductor material layer (2);
    a plurality of elementary functional units, each elementary functional unit comprising a continuous body region (3) of a second conductivity type opposite to the first formed in the semiconductor material layer (2), the body region (3) having the form of a body stripe elongated in a longitudinal direction on a surface of the semiconductor layer (2), each elementary functional unit further comprising an elongated window (12) in the conductive insulated gate layer (7, 8, 9) extending along said longitudinal direction and above said elongated body stripe (3),
    each body stripe (3) including a plurality of source portions (60; 61; 62) aligned along said longitudinal direction of the body stripe (3), doped with dopants of the first conductivity type and intercalated along said longitudinal direction with body portions (40; 41; 3') of the body stripe (3) wherein no dopant of the first conductivity type are provided;
    said conductive insulated gate layer (7, 8, 9) comprising a first insulating material layer ('7) placed above the semiconductor material layer (2), a conductive material layer (8) placed above the first insulating material layer (7), and a second insulating material layer (9) placed above the conductive material layer (8);
    said conductive insulated gate layer (7, 8, 9) comprising a plurality of parallel portions each one having the shape of a stripe elongated in said longitudinal direction on a surface of the semiconductor layer (2), said insulated gate layer portions being parallel to alternated to and extending partially over said body stripes (3) each one of said insulated gate layer portions being delimited by two contact windows (12), said insulated gate layer portions extending in a transversal direction to the stripe,
    the device further comprising insulating material sidewall spacers (13) to seal laterally and along said longitudinal direction the edges of said elongated window (12) in the conductive insulated gate layer (7, 8, 9), said device comprising a metal layer (10) on the semiconductor material layer and the conductive insulated gate layer (7, 8, 9), said metal layer (10) contacting the body portions (40; 41; 3') and the source portions (60; 61; 62) of the body stripe (3) through the said elongated contact window (12) and said sidewall spacers (13),
    each body stripe (3) comprising a central heavily doped deep body stripe (17) and two lateral lightly doped channel stripes (18),

    **characterized in that** said central heavily doped deep body stripe (17) is laterally aligned with the edges of said elongated contact window (12) in the conductive insulated gate layer (7, 8, 9) and **in that** each source portion (60; 61; 62) is disposed completely above the peak concentration of dopants of the respective portion of said central heavily doped deep body stripe (17).

2.  MOS technology power device according to claim 1, **characterized in that** said first insulating material layer (7) is an oxide Layer, said conductive material Layer (8) is a polysilicon layer, and said second insulating material layer (9) is a passivation layer.

3. MOS technology power device according to claim 2, **characterized in that** said polysilicon Layer is a doped polysilicon Layer with low resistivity.

4. MOS technology power device according to claim 2, **characterized in that** said conductive insulated gate Layer (7,8,9) further comprises a silicide layer interposed between the polysilicon layer (8) and the passivation Layer (9).

5. MOS technology power device according to claim 4, **characterized in that** said silicide layer is a cobalt silicide layer.

6. MOS technology power device according to claim 1, **characterized in that** each body stripe (3) comprises a plurality of source portions (60) extending in a direction transversal to the body stripe (3) and doped with dopants of the first conductivity type, intercalated in the longitudinal direction of the body stripe (3) with body portions (40) of the body stripe (3) extending in the transversal direction and wherein no dopants of the first conductivity type are provided.

7. MOS technology power device according to claim 6, **characterized in that** the dimension (Lu) of said source portions (60) along the longitudinal direction is substantially targer than a the dimension (s) of said body portions (40) along the longitudinal direction.

8. MOS technoLogy power device according to claim 7 comprising a plurality of substantially parallel body stripes (3), **characterized in that** the source portions (60) and the body portions (40) of a body stripe (3) are substantially aligned in the transversal direction respectively with the source portions (60) and the body portions (40) of adjacent body stripes (3).

9. MOS technology power device according to claim 7 comprising a plurality of substantially parallel body stripes (3), **characterized in that** the source portions (60) and the body portions (40) of a body stripe (3) are substantially aligned in the transversal direction respectively with the body portions (40) and the source portions (60) of adjacent body stripes (3).

10. MOS technology power device according to claim 6, **characterized in that** the dimension (Lu) of said source portions (60) along the longitutinal direction is substantially equal to the dimension (s) of said body portions (40) along the longitudinale direction.

11. MOS technology power device according to claim 10, **characterized in that** the source portions (60) and the body portions (40) of a body stripe (3) are substantially aligned in the transversal direction respectively with the body portions (40) and the source portions (60) of adjacent body stripes (3).

12. MOS technology power device according to claim 1, **characterized in that** each body stripe (3) comprises a first longitudinal half-stripe (3') and a second longitudinal half-stripe (3") merged together, each half-stripe (3',3") comprising a plurality of source portions (61) extending in a direction transversal to the half-stripe (3',3") and doped with dopants of the first conductivity type, intercalated in the LongitudinaL direction of the half-stripe with body portions (41) of the half-stripe (3',3") extending in the transversal direction and wherein no dopants of the first conductivity type are provided, the source portions (61) and the body portions (41) of one half-stripe (3',3") being aligned in the transversal direction respectively with the body portions (41) and the source portions (61) of the other half-stripe (3',3").

13. MOS technology power device according to claim 12 comprising a plurality of substantially parallel body stripes (3), **characterized in that** the source portions (61) of a body stripe (3) are located adjacent to the body portions (41) of "adjacent body stripes (3) along the transversal direction.

14. MOS technology power device according to claim 1, **characterized in that** each body stripe (3) comprises a first LongitudinaL half-stripe (3") and a second LongitudinaL hal.f-stripe (3') merged together, the first LongitudinaL half-stripe (3") including an elongated source portion (62) extending in the longitudinal direction substantially for the whole length of the half-stripe (3") and doped with dopants of the first conductivity type, and the second half-stripe (3') forming an elongated body portion extending in the longitudinal direction substantially for the whole length of the half-stripe (3') and wherein no dopants of the first conductivity type are provided.

**15.** MOS technology power device according to claim 14 comprising a plurality of substantially parallel body stripes (3), **characterized in that** said elongated source portion (62) of a body stripe (3) is adjacent to the elongated body portion of an adjacent body stripe (3) along the transversal direction.

**16.** MOS technology power device according to anyone of the preceding claims, **characterized in that** said semiconductor material layer (2) is superimposed over a semiconductor material substrate (1).

**17.** MOS technology power device according to claim 16, **characterized in that** said semiconductor material layer (2) is lightly doped, and said semiconductor material substrate (1) is heavily doped.

**18.** MOS technology power device according to claim 17, **characterized in that** said semiconductor material substrate (1) is of the first conductivity type.

**19.** MOS technology power device according to claim 17, **characterized in that** said semiconductor material substrate (1) is of the second conductivity type.

**20.** MOS technology power device according to anyone of the preceding claims, **characterized in that** said first conductivity type is the N conductivity type, and said second conductivity type is the P conductivity type.

**21.** MOS technology power device according to anyone of claims 1-20, **characterized in that** said first conductivity type is the P conductivity type, and said second conductivity type is the N conductivity type.

**22.** Process of manufacturing an MOS technology power device according to claim 1, comprising the steps of:

forming a first insulating material layer (7) over a semiconductor material layer (2) of a first conductivity type;
forming a first conductive material layer (8) over the first insulating material layer (7);
forming a second insulating material layer (9) over the first conductive material layer (8);
selectively removing by a mask and an etch the second insulating material layer (9) and the first conductive material layer (8) to open a plurality of windows (12) elongated in a longitudinal direction on a surface of the semiconductor layer (2) and to form a plurality of stripes parallel and alternated to the windows (12) and delimited by them, said stripes being made by first portions of the first conductive material layer (8) and second portions of the second insulating material layer (9) which extend in a direction transversal to the stripes and have equal dimension along the transversal direction;
forming a body stripe (3) of a second conductivity type opposite to the first in the semiconductor material layer (2) under each elongated window (12), wherein in each body stripe (3) a central heavily doped deep body stripe (17) and two lateral lightly doped channel stripes (18) are formed, said central heavily deep body stripe (17) being aligned with the edges of said elongated window (12) in the insulating gate layer (7, 8, 9) the peak concentration of dopant of the heavily doped deep body stripe being located under the source portions (60; 61; 62) to be formed in a later step
forming in said body stripe (3) a plurality of source portions (60;61;62) doped with dopant of the first conductivity type, in such a way as to be intercalated with body portions (40;41;3') of the body stripe (3) wherein no dopants of the first conductivity type are provided, each source portion (60; 61; 62) being disposed completely above a respective portion of said central heavily deep body stripe (17);
forming insulating material sidewall spacers (13) along the edges of each window (12); then
forming a second conductive material layer (10) over the second insulating material layer (9), the second conductive material layer (10) contacting said source portions (60;61;62) and said body portion (40;41;3').

**23.** Manufacturing process according to claim 22, **characterized in that** the step of forming said body stripe (3) provides for selectively introducing a dopant of the second conductivity type into the semiconductor material layer (2) using said second insulating material layer (9) as a mask.

**24.** Manufacturing process according to claim 23, **characterized in that** the step of forming said body stripe (3) provides for:

performing an implant of a dopant of the second conductivity type at a prescribed high energy and in a heavy dose using the second insulating material layer (9) as a mask, said energy being sufficient to locate a peak concentration of the dopant at a prescribed distance from the surface of the semiconductor material layer (2) under the source portions (60;61;62);

performing a thermal diffusion of the implanted dopant with a prescribed thermal budget so that the body stripe (3) comprises said central heavily doped deep body stripe (17) and said two lateral lightly doped channel stripes (18).

**25.** Manufacturing process according to claim 24, **characterized in that** the step of forming said body stripe (3) provides for:

performing a first implant of a dopant of the second conductivity type using the second insulating materiaL Layer (9) as a mask, with an implant energy suitable to locate the peak dopant concentration substantially at the surface of the semiconductor material layer, the implant dose determining the threshold voltage of the MOS power device;
performing a second implant of a dopant of the second conductivity type using the second insulating material layer (9) as a mask, with an implant dose substantially higher than that of the first implant, the implant energy being suitable to Locate the peak dopant concentration at a prescribed distance from the surface of the semiconductor material layer (2) under the source portions (60;61;62);
performing a thermal diffusion process.

**26.** Manufacturing process according to claim 22, **characterized in that** said first insulating material layer (7) is a silicon dioxide layer, said first conductive material Layer (8) is a doped polysilicon layer, and said second insulating material Layer (9) is a passivation Layer.

**27.** Manufacturing process according to claim 23, **characterized in that** the step of selectively removing of the second insulating material layer (9) and the first conductive material Layer (8) is performed by means of a unique photolithography, said elongated window (12) having a dimension (Lp) along the transversal direction substantially equal to the optical resolution limit (f) of the photolithographic apparatus used to perform said photolithography.

**28.** Manufacturing process according to claim 22, **characterized in that** said first conductive material layer (8) comprises a doped polysilicon layer and a silicide layer.

**29.** Manufacturing process according to claim 28, **characterized in that** said silicide layer is a cobalt silicide layer.

**30.** Manufacturing process according to claim 22, **characterized in that** it provides for forming a plurality of said elongated windows (12) substantially parallel with one another, and for forming in the semiconductor material Layer (2) a respective plurality of body stripes (3) of the second conductivity type.

**31.** Manufacturing process according to anyone of claims 22 to 31, **characterized in that** said semiconductor material Layer (2) is a lightly doped layer epitaxially grown over a heavily doped semiconductor substrate (1).

**32.** Manufacturing process according to claim 31, **characterized in that** said semiconductor substrate (1) is of the first conductivity type.

**33.** Manufacturing process according to claim 31, **characterized in that** said semiconductor substrate is of the second conductivity type.

**Revendications**

**1.** Dispositif de puissance en technologie MOS comprenant :

une couche de semiconducteur (2) ayant un premier type de conductivité ;
une couche de grille conductrice isolée (7, 8, 9) recouvrant la couche de matériau semiconducteur (2) ;
une pluralité d'unités fonctionnelles élémentaires, chaque unité fonctionnelle élémentaire comprenant une région de corps continue (3) ayant un deuxième type de conductivité, opposé au premier, formée dans la couche de matériau semiconducteur (2), la région de corps (3) ayant la forme d'une bande de corps allongée dans une direction longitudinale sur une surface de la couche de semiconducteur (2), chaque unité fonctionnelle élémentaire comprenant en outre une fenêtre allongée (12) dans la couche de grille conductrice isolée (7, 8, 9) s'étendant suivant ladite direction longitudinale et au-dessus de ladite bande de corps allongée (3),
chaque bande de corps (3) incluant une pluralité de parties de source (60 ; 61 ; 62) alignées suivant ladite direction longitudinale de la bande de corps (3), dopées avec des impuretés du premier type de conductivité et intercalées suivant ladite direction longitudinale avec des parties de corps (40 ; 41 ; 3') de la bande de corps (3) dans lesquelles il n'y a pas d'impuretés du premier type de conductivité ;

ladite couche de grille conductrice isolée (7, 8, 9) comprenant une première couche de matériau isolant (7) placée au-dessus de la couche de matériau semiconducteur (2), une couche de matériau conducteur (8) placée au-dessus de la première couche de matériau isolant (7) et une deuxième couche de matériau isolant (9) placée au-dessus de la couche de matériau conducteur (8) ;

ladite couche de grille conductrice isolée (7, 8, 9) comprenant une pluralité de parties parallèles ayant chacune la forme d'une bande allongée dans ladite direction longitudinale sur une surface de la couche de semiconducteur (2), lesdites parties de couche de grille isolée étant parallèles à, alternées avec et s'étendant partiellement sur lesdites bandes de corps (3), chacune desdites parties de couche de grille isolée étant délimitée par deux fenêtres de contact (12), lesdites parties de couche de grille isolée s'étendant dans une direction transversale à la bande,

le dispositif comprenant en outre des parois d'espacement latérales en matériau isolant (13) pour rendre étanches latéralement et dans ladite direction longitudinale les bords de ladite fenêtre allongée (12) dans la couche de grille conductrice isolée (7, 8, 9),

ledit dispositif comprenant une couche de métal (10) sur la couche de matériau semiconducteur et la couche de grille conductrice isolée (7, 8, 9), ladite couche de métal (10) touchant les parties de corps (40 ; 41 ; 3') et les parties de source (60 ; 61 ; 62) de la bande de corps (3) à travers ladite fenêtre de contact allongée (12) et lesdites parois d'espacement latérales (13),

chaque bande de corps (3) comprenant une bande de corps profonde, centrale et fortement dopée (17) et deux bandes de canal latérales légèrement dopées (18),

**caractérisé en ce que** ladite bande de corps profonde, centrale et fortement dopée (17) est alignée latéralement avec les bords de ladite fenêtre de contact allongée (12) dans la couche de grille conductrice isolée (7, 8, 9), et **en ce que** chaque partie de source (60 ; 61 ; 62) est disposée complètement au-dessus de la concentration maximale d'impuretés de la partie respective de ladite bande de corps profonde, centrale et fortement dopée (17).

2. Dispositif de puissance en technologie MOS selon la revendication 1, **caractérisé en ce que** ladite première couche de matériau isolant (7) est une couche d'oxyde, ladite couche de matériau conducteur (8) est une couche de polysilicium, et ladite deuxième couche de matériau isolant (9) est une couche de passivation.

3. Dispositif de puissance en technologie MOS selon la revendication 2, **caractérisé en ce que** ladite couche de polysilicium est une couche de polysilicium dopé à faible résistivité.

4. Dispositif de puissance en technologie MOS selon la revendication 2, **caractérisé en ce que** ladite couche de grille conductrice isolée (7, 8, 9) comprend en outre une couche de siliciure intercalée entre la couche de polysilicium (8) et la couche de passivation (9).

5. Dispositif de puissance en technologie MOS selon la revendication 4, **caractérisé en ce que** ladite couche de siliciure est une couche de siliciure au cobalt.

6. Dispositif de puissance en technologie MOS selon la revendication 1, **caractérisé en ce que** chaque bande de corps (3) comprend une pluralité de parties de source (60) qui s'étendent dans une direction transversale à la bande de corps (3) et dopées avec des impuretés ayant le premier type de conductivité, intercalées dans la direction longitudinale de la bande de corps (3) avec des parties de corps (40) de la bande de corps (3) s'étendant dans la direction transversale et ne contenant pas d'impuretés du premier type de conductivité.

7. Dispositif de puissance en technologie MOS selon la revendication 6, **caractérisé en ce que** la dimension (Lu) desdites parties de source (60) dans la direction longitudinale est substantiellement plus grande que la dimension (s) desdites parties de corps (40) le long de la direction longitudinale.

8. Dispositif de puissance en technologie MOS selon la revendication 7, comprenant une pluralité de bandes de corps substantiellement parallèles (3), **caractérisé en ce que** les parties de source (60) et les parties de corps (40) d'une bande de corps (3) sont substantiellement alignées dans la direction transversale respectivement avec les parties de source (60) et les parties de corps (40) de bandes de corps (3) voisines.

9. Dispositif de puissance en technologie MOS selon la revendication 7, comprenant une pluralité de bandes de corps substantiellement parallèles (3), **caractérisé en ce que** les parties de source (60) et les parties de corps (40) d'une bande de corps (3) sont substantiellement alignées dans la direction transversale respectivement avec les parties de corps (40) et les parties de source (60) de bandes de corps (3) voisines.

10. Dispositif de puissance en technologie MOS selon la revendication 6, **caractérisé en ce que** la dimension (Lu) desdites parties de source (60) dans la direction longitudinale est sensiblement égale à la dimension (s) desdites parties de corps (40) le long de la direction longitudinale.

11. Dispositif de puissance en technologie MOS selon la revendication 10, **caractérisé en ce que** les parties de source (60) et les parties de corps (40) d'une bande de corps (3) sont substantiellement alignées dans la direction transversale respectivement avec les parties de corps (40) et les parties de source (60) de bandes de corps (3) voisines.

12. Dispositif de puissance en technologie MOS selon la revendication 1, **caractérisé en ce que** chaque bande de corps (3) comprend une première demi bande longitudinale (3') et une deuxième demi bande longitudinale (3") imbriquées, chaque demi bande (3', 3") comprenant une pluralité de parties de source (61) s'étendant dans une direction transversale à la demi bande (3', 3") et dopées avec des impuretés ayant le premier type de conductivité, intercalées dans la direction longitudinale de la demi bande, les parties corps (41) de la demi bande (3', 3") s'étendant dans la direction transversale et ne contenant pas d'impuretés du premier type de conductivité, les parties de source (61) et les parties de corps (41) d'une demi bande (3', 3") étant alignées dans la direction transversale respectivement avec les parties de corps (41) et les parties de source (61) de l'autre demi bande (3' 3").

13. Dispositif de puissance en technologie MOS selon la revendication 12, comprenant une pluralité de bandes de corps substantiellement parallèles (3), **caractérisé en ce que** les parties de source (61) d'une bande de corps (3) sont adjacentes aux parties de corps (41) de bandes de corps voisines (3) dans la direction transversale.

14. Dispositif de puissance en technologie MOS selon la revendication 1, **caractérisé en ce que** chaque bande de corps (3) comprend une première demi bande longitudinale (3") et une deuxième demi bande longitudinale (3') imbriquées, la première demi bande longitudinale (3") incluant une partie de source allongée (62) s'étendant dans la direction longitudinale substantiellement sur toute la longueur de la demi bande (3") et dopée avec des impuretés ayant le premier type de conductivité, et la deuxième demi bande (3') formant une partie de corps allongée s'étendant dans la direction longitudinale substantiellement sur toute la longueur de la demi bande (3') et ne contenant pas d'impuretés ayant le premier type de conductivité.

15. Dispositif de puissance en technologie MOS selon la revendication 14, comprenant une pluralité de bandes de corps substantiellement parallèles (3), **caractérisé en ce que** ladite partie de source allongée (62) d'une bande de corps (3) est adjacente à la partie de corps allongée d'une bande de corps (3) voisine suivant la direction transversale.

16. Dispositif de puissance en technologie MOS selon l'une quelconque des revendications précédentes, **caractérisé en ce que** ladite couche de matériau semiconducteur (2) est superposée sur un substrat en matériau semiconducteur (1).

17. Dispositif de puissance en technologie MOS selon la revendication 16, **caractérisé en ce que** ladite couche de matériau semiconducteur (2) est légèrement dopée, et ledit substrat en matériau semiconducteur (1) est fortement dopé.

18. Dispositif de puissance en technologie MOS selon la revendication 17, **caractérisé en ce que** ledit substrat en matériau semiconducteur (1) a le premier type de conductivité.

19. Dispositif de puissance en technologie MOS selon la revendication 17, **caractérisé en ce que** ledit substrat en matériau semiconducteur (1) a le deuxième type de conductivité.

20. Dispositif de puissance en technologie MOS selon l'une quelconque des revendications précédentes, **caractérisé en ce que** ledit premier type de conductivité est le type de conductivité N, et ledit deuxième type de conductivité est le type de conductivité P.

21. Dispositif de puissance en technologie MOS selon l'une quelconque des revendications 1 à 20, **caractérisé en ce que** ledit premier type de conductivité est le type de conductivité P, et ledit deuxième type de conductivité est le type de conductivité N.

**22.** Procédé de fabrication d'un dispositif de puissance en technologie MOS conforme à la revendication 1, comprenant les étapes consistant à :

former une première couche de matériau isolant (7) par dessus une couche de matériau semiconducteur (2) ayant un premier type de conductivité ;
former une première couche de matériau conducteur (8) sur la première couche de matériau isolant (7) ;
former une deuxième couche de matériau isolant (9) sur la première couche de matériau conducteur (8) ;
enlever sélectivement au moyen d'un masque et d'une gravure la deuxième couche de matériau isolant (9) et la première couche de matériau conducteur (8) pour ouvrir une pluralité de fenêtres (12) allongées dans une direction longitudinale sur une surface de la couche de semiconducteur (2) et pour former une pluralité de bandes parallèles et alternées aux fenêtres (12) et délimitées par elles, lesdites bandes étant constituées par des premières parties de la première couche de matériau conducteur (8) et des deuxièmes paries de la deuxième couche de matériau isolant (9) qui s'étendent dans une direction transversale aux bandes et ont des dimensions égales suivant la direction transversale ;
former une bande de corps (3) ayant un deuxième type de conductivité, opposé au premier, dans la couche de matériau semiconducteur (2), sous chaque fenêtre allongée (12), où, dans chaque bande de corps (3), sont formées une bande de corps profonde, centrale et fortement dopée (17) et deux bandes de canal latérales légèrement dopées (18), ladite bande de corps profonde, centrale et fortement dopée (17) étant alignée avec les bords de ladite fenêtre allongée (12) dans la couche de grille isolante (7, 8, 9), la concentration maximale d'impuretés de la bande de corps profonde fortement dopée étant située sous les parties de source (60 ; 61 ; 62) devant être formées dans une étape ultérieure ;
former dans ladite bande de corps (3) une pluralité de parties de source (60 ; 61 ; 62) dopées avec des impuretés du premier type de conductivité, de telle façon qu'elles soient intercalées avec des parties de corps (40 ; 41 ; 3') de la bande de corps (3) dans lesquelles il n'y a pas d'impuretés du premier type de conductivité, chaque partie de source (60 ; 61 ; 62) étant placée complètement au-dessus d'une partie respective de ladite bande de corps profonde, centrale et fortement dopée (17) ;
former des parois d'espacement latérales en matériau isolant (13) le long des bords de chaque fenêtre (12) ; puis former une deuxième couche de matériau conducteur (10) sur la deuxième couche de matériau isolant (9), la deuxième couche de matériau conducteur (10) touchant lesdites parties de source (60 ; 61 ; 62) et ladite partie de corps (40 ; 41 ; 3').

**23.** Procédé de fabrication selon la revendication 22, **caractérisé en ce que** l'étape de formation de ladite bande de corps (3) prévoit l'introduction sélective d'impuretés ayant le deuxième type de conductivité dans la couche de matériau semiconducteur (2) en utilisant ladite deuxième couche de matériau isolant (9) comme masque.

**24.** Procédé de fabrication selon la revendication 23, **caractérisé en ce que** l'étape de formation de ladite bande de corps (3) prévoit les opérations consistant à :

exécuter l'implantation d'impuretés ayant le deuxième type de conductivité, avec une énergie haute prescrite et à forte dose en utilisant la deuxième couche de matériau isolant (9) comme masque, ladite énergie étant suffisante pour localiser une concentration maximale des impuretés à une distance prescrite de la surface de la couche de matériau semiconducteur (2) sous les parties de source (60 ; 61 ; 62) ;
exécuter une diffusion thermique des impuretés implantées avec un bilan thermique prescrit, de sorte que la bande de corps (3) comprend ladite bande de corps profonde, centrale et fortement dopée (17) et lesdites deux bandes de canal latérales légèrement dopées (18).

**25.** Procédé de fabrication selon la revendication 24, **caractérisé en ce que** l'étape de formation de ladite bande de corps (3) prévoit les opérations consistant à :

exécuter une première implantation d'impuretés ayant le deuxième type de conductivité en utilisant la deuxième couche de matériau isolant (9) comme masque, avec une énergie d'implantation adaptée pour localiser la concentration maximale en impuretés substantiellement à la surface de la couche de matériau semiconducteur, la dose d'implantation déterminant la tension de seuil du dispositif de puissance à technologie MOS ;
exécuter une deuxième implantation d'impuretés ayant le deuxième type de conductivité en utilisant la deuxième couche de matériau isolant (9) comme masque, avec une dose d'implantation substantiellement supérieure à celle de la première implantation, l'énergie d'implantation étant adaptée pour localiser la concentration maximale en impuretés à une distance prescrite de la surface de la couche de matériau semiconducteur (2) sous les parties de source (60 ; 61 ; 62) ;

exécuter un processus de diffusion thermique.

26. Procédé de fabrication selon la revendication 22, **caractérisé en ce que** ladite première couche de matériau isolant (7) est une couche de dioxyde de silicium, ladite première couche de matériau conducteur (8) est une couche de polysilicium dopé, et ladite deuxième couche de matériau isolant (9) est une couche de passivation.

27. Procédé de fabrication selon la revendication 23, **caractérisé en ce que** l'étape de retrait sélectif de la deuxième couche de matériau isolant (9) et de la première couche de matériau conducteur (8) est exécutée au moyen d'une photolithographie unique, ladite fenêtre allongée (12) ayant une dimension (Lp) suivant la direction transversale substantiellement égale à la limite de résolution optique (f) de l'appareil photolithographique utilisé pour exécuter ladite photolithographie.

28. Procédé de fabrication selon la revendication 22, **caractérisé en ce que** ladite première couche de matériau conducteur (8) comprend une couche de polysilicium dopé et une couche de siliciure.

29. Procédé de fabrication selon la revendication 28, **caractérisé en ce que** ladite couche de siliciure est une couche de siliciure de cobalt.

30. Procédé de fabrication selon la revendication 22, **caractérisé en ce qu'**il prévoit la formation d'une pluralité desdites fenêtres allongées (12) substantiellement parallèles entre elles, et la formation dans la couche de matériau semiconducteur (2) d'une pluralité respective de bandes de corps (3) ayant le deuxième type de conductivité.

31. Procédé de fabrication selon l'une quelconque des revendications 22 à 31, **caractérisé en ce que** ladite couche de matériau semiconducteur (2) est une couche légèrement dopée formée par croissance épitaxiale sur un substrat en semiconducteur fortement dopé (1).

32. Procédé de fabrication selon la revendication 31, **caractérisé en ce que** ledit substrat semiconducteur (1) a le premier type de conductivité.

33. Procédé de fabrication selon la revendication 31, **caractérisé en ce que** ledit substrat semiconducteur a le deuxième type de conductivité.


**Patentansprüche**

1. Leistungsvorrichtung in MOS-Technologie, die folgendes aufweist:

eine Halbleiterschicht (2) eines ersten Leitfähigkeitstyps;
eine leitende isolierte Gate-Schicht (7, 8, 9), die die Halbleitermaterialschicht (2) bedeckt;
eine Vielzahl von elementaren funktionellen Einheiten, wobei jede elementare funktionelle Einheit einen in der Halbleitermaterialschicht (2) ausgebildeten kontinuierlichen Körperbereich (3) eines zweiten Leitfähigkeitstyps aufweist, der entgegengesetzt zum ersten ist, wobei der Körperbereich (3) die Form eines in einer Längsrichtung auf einer Oberfläche der Halbleiterschicht (2) länglichen Körperstreifens hat, wobei jede elementare funktionelle Einheit weiterhin ein längliches Fenster (12) in der leitenden isolierten Gate-Schicht (7, 8, 9) aufweist, das sich entlang der Längsrichtung und über dem länglichen Körperstreifen (3) erstreckt,

wobei jeder Körperstreifen (3) eine Vielzahl von Source-Teilen (60; 61; 62) enthält, die entlang der Längsrichtung des Körperstreifens (3) ausgerichtet sind, die mit Dotierungsmitteln des ersten Leitfähigkeitstyps dotiert sind und zwischen welche entlang der Längsrichtung Körperteile (40; 41; 3') des Körperstreifens (3) eingeschoben sind, in welchen kein Dotierungsmittel des ersten Leitfähigkeitstyps vorgesehen ist;
wobei die leitende isolierte Gate-Schicht (7, 8, 9) eine über der Halbleitermaterialschicht (2) angeordnete erste Isoliermaterialschicht (7), eine über der ersten Isoliermaterialschicht (7) angeordnete Schicht (8) aus leitendem Material und eine über der Schicht (8) aus leitendem Material angeordnete zweite Isoliermaterialschicht (9) aufweist;
wobei die leitende isolierte Gate-Schicht (7, 8, 9) eine Vielzahl von parallelen Teilen aufweist, von welchen jeder die Form eines Streifens hat, der in der Längsrichtung auf einer Oberfläche der Halbleiterschicht (2) länglich bzw. ausgedehnt ist, wobei die Teile der isolierten Gate-Schicht parallel zu und abwechselnd zu und sich teilweise erstreckend über den Körperstreifen (3) sind, wobei jeder der Teile der isolierten Gate-Schicht durch zwei Kontaktfenster (12) begrenzt ist, wobei sich die Teile der isolierten Gate-Schicht in einer transversalen Richtung zum Streifen erstrecken,

wobei die Vorrichtung weiterhin Seitenwandabstandsstücke (13) aus isolierendem Material aufweist, um in lateraler Richtung und entlang der Längsrichtung Ränder des länglichen Fensters (12) in der leitenden isolierten Gate-Schicht (7, 8, 9) abzudichten,

wobei die Vorrichtung eine Metallschicht (10) auf der Halbleitermaterialschicht und der leitenden isolierten Gate-Schicht (7, 8, 9) aufweist, wobei die Metallschicht (10) die Körperteile (40; 41; 3') und die Source-Teile (60; 61; 62) des Körperstreifens (3) durch das längliche Kontaktfenster (12) und die Seitenwandabstandsstücke (13) kontaktiert,

wobei jeder Körperstreifen (3) einen zentralen stark dotierten tiefen Körperstreifen (17) und zwei laterale leicht dotierte Kanalstreifen (18) aufweist,

**dadurch gekennzeichnet, dass**

der zentrale stark dotierte tiefe Körperstreifen (17) mit den Rändern des länglichen Kontaktfensters (12) in der leitenden isolierten Gate-Schicht (7, 8, 9) in lateraler Richtung ausgerichtet ist, und

dass jeder Source-Teil (60; 61; 62) vollständig über der Spitzenkonzentration von Dotierungsmitteln des jeweiligen Teils des zentralen stark dotierten tiefen Körperstreifens (17) angeordnet ist.

2. Leistungsvorrichtung in MOS-Technologie nach Anspruch 1, **dadurch gekennzeichnet, dass** die erste Isoliermaterialschicht (7) eine Oxidschicht ist, die Schicht (8) aus leitendem Material eine Polysiliziumschicht ist und die zweite Isoliermaterialschicht (9) eine Passivierungsschicht ist

3. Leistungsvorrichtung in MOS-Technologie nach Anspruch 2, **dadurch gekennzeichnet, dass** die Polysiliziumschicht eine dotierte Polysiliziumschicht mit niedrigem Widerstand ist.

4. Leistungsvorrichtung in MOS-Technologie nach Anspruch 2, **dadurch gekennzeichnet, dass** die leitende isolierte Gate-Schicht (7, 8, 9) weiterhin eine Silizidschicht aufweist, die zwischen der Polysiliziumschicht (8) und der Passivierungsschicht (9) angeordnet ist.

5. Leistungsvorrichtung in MOS-Technologie nach Anspruch 4, **dadurch gekennzeichnet, dass** die Silizidschicht eine Kobaltsilizidschicht ist.

6. Leistungsvorrichtung in MOS-Technologie nach Anspruch 1, **dadurch gekennzeichnet, dass** jeder Körperstreifen (3) eine Vielzahl von Source-Teilen (60) aufinreist, die sich in einer Richtung transversal zu dem Körperstreifen (3) erstrecken und die mit Dotierungsmitteln des ersten Leitfähigkeitstyps dotiert sind, zwischen denen in der Längsrichtung des Körperstreifens (3) Körperteile (40) des Körperstreifens (3) eingeschoben sind, die sich in der transversalen Richtung erstrecken und in welchen keine Dotierungsmittel des ersten Leitfähigkeitstyps vorgesehen sind.

7. Leistungsvorrichtung in MOS-Technologie nach Anspruch 6, **dadurch gekennzeichnet, dass** die Dimension (Lu) der Source-Teile (60) entlang der Längsrichtung wesentlich größer als die Dimension (s) der Körperteile (40) entlang der Längsrichtung ist.

8. Leistungsvorrichtung in MOS-Technologie nach Anspruch 7, die eine Vielzahl von im Wesentlichen parallelen Körperstreifen (3) aufweist, **dadurch gekennzeichnet, dass** die Source-Teile (60) und die Körperteile (40) eines Körperstreifens (3) in der transversalen Richtung jeweils im Wesentlichen mit den Source-Teilen (60) und den Körperteilen (40) von benachbarten Körperstreifen (3) ausgerichtet sind.

9. Leistungsvorrichtung in MOS-Technologie nach Anspruch 7, die eine Vielzahl von im Wesentlichen parallelen Körperstreifen (3) aufweist, **dadurch gekennzeichnet, dass** die Source-Teile (60) und die Körperteile (40) eines Körperstreifens (3) in der transversalen Richtung jeweils im Wesentlichen mit den Körperteilen (40) und den Source-Teilen (60) von benachbarten Körperstreifen (3) ausgerichtet sind.

10. Leistungsvorrichtung in MOS-Technologie nach Anspruch 6, **dadurch gekennzeichnet, dass** die Dimension (Lu) der Source-Teile (60) entlang der Längsrichtung im Wesentlichen gleich der Dimension (s) der Körperteile (40) entlang der Längsrichtung ist.

11. Leistungsvorrichtung in MOS-Technologie nach Anspruch 10, **dadurch gekennzeichnet, dass** die Source-Teile (60) und die Körperteile (40) eines Körperstreifens (3) in der transversalen Richtung jeweils im Wesentlichen mit den Körperteilen (40) und den Source-Teilen (40) von benachbarten Körperstreifen (3) ausgerichtet sind.

**12.** Leistungsvorrichtung in MOS-Technologie nach Anspruch 1, **dadurch gekennzeichnet, dass** jeder Körperstreifen (3) einen ersten longitudinalen Halbstreifen (3') und einen zweiten longitudinalen Halbstreifen (3") aufweist, die miteinander verbunden sind, wobei jeder Halbstreifen (3', 3") eine Vielzahl von Source-Teilen (61) aufweist, die sich in einer Richtung transversal zu dem Halbstreifen (3', 3") erstrecken und die mit Dotierungsmitteln des ersten Leitfähigkeitstyps dotiert sind und zwischen welchen in der Längsrichtung des Halbstreifens Körperteile (41) des Halbstreifens (3', 3") eingeschoben sind, die sich in der transversalen Richtung erstrecken und in welchen keine Dotierungsmittel des ersten Leitfähigkeitstyps vorgesehen sind, wobei die Source-Teile (61) und die Körperteile (41) von einem Halbstreifen (3', 3") in der transversalen Richtung jeweils mit den Körperteilen (41) und den Source-Teilen (61) des anderen Halbstreifens (3', 3") ausgerichtet sind.

**13.** Leistungsvorrichtung in MOS-Technologie nach Anspruch 12, die eine Vielzahl von im Wesentlichen parallelen Körperstreifen (3) aufweist, **dadurch gekennzeichnet, dass** die Source-Teile (61) eines Körperstreifens (3) benachbart zu den Körperteilen (41) von benachbarten Körperstreifen (3) entlang der transversalen Richtung angeordnet sind.

**14.** Leistungsvorrichtung in MOS-Technologie nach Anspruch 1, **dadurch gekennzeichnet, dass** jeder Körperstreifen (3) einen ersten longitudinalen Halbstreifen (3") und einen zweiten longitudinalen Halbstreifen (3') aufweist, die miteinander verbunden sind, wobei der erste longitudinale Halbstreifen (3") einen länglichen Source-Teil (62) enthält, der sich in der Längsrichtung im Wesentlichen für die gesamte Länge des Halbstreifens (3") erstreckt und der mit Dotierungsmitteln des ersten Leitfähigkeitstyps dotiert ist, und wobei der zweite Halbstreifen (3') einen länglichen Körperteil ausbildet, der sich in der Längsrichtung im Wesentlichen für die gesamte Länge des Halbstreifens (3') erstreckt und in welchem keine Dotierungsmittel des ersten Leitfähigkeitstyps vorgesehen sind.

**15.** Leistungsvorrichtung in MOS-Technologie nach Anspruch 14, die eine Vielzahl von im Wesentlichen parallelen Körperstreifen (3) aufweist, **dadurch gekennzeichnet, dass** der längliche Source-Teil (62) eines Körperstreifens (3) benachbart zu dem länglichen Körperteil eines benachbarten Körperstreifens (3) entlang der transversalen Richtung ist.

**16.** Leistungsvorrichtung in MOS-Technologie nach einem der vorangehenden Ansprüche, **dadurch gekennzeichnet, dass** die Halbleitermaterialschicht (2) einem Halbleitermaterialsubstrat (1) überlagert ist.

**17.** Leistungsvorrichtung in MOS-Technologie nach Anspruch 6, **dadurch gekennzeichnet, dass** die Halbleitermaterialschicht (2) leicht dotiert ist und das Halbleitermaterialsubstrat (1) stark dotiert ist.

**18.** Leistungsvorrichtung in MOS-Technologie nach Anspruch 17, **dadurch gekennzeichnet, dass** das Halbleitermaterialsubstrat (1) vom ersten Leitfähigkeitstyp ist.

**19.** Leistungsvorrichtung in MOS-Technologie nach Anspruch 17, **dadurch gekennzeichnet, dass** das Halbleitermaterialsubstrat (1) vom zweiten Leitfähigkeitstyp ist.

**20.** Leistungsvorrichtung in MOS-Technologie nach einem der vorangehenden Ansprüche, **dadurch gekennzeichnet, dass** der erste Leitfähigkeitstyp der N-Leitfähigkeitstyp ist und der zweite Leitfähigkeitstyp der P-Leitfähigkeitstyp ist.

**21.** Leistungsvorrichtung in MOS-Technologie nach einem der Ansprüche 1 - 19, **dadurch gekennzeichnet, dass** der erste Leitfähigkeitstyp der P-Leitfähigkeitstyp ist und der zweite Leitfähigkeitstyp der N-Leitfähigkeitstyp ist.

**22.** Verfahren zum Herstellen einer Leistungsvorrichtung in MOS-Technologie nach Anspruch 1, das die folgenden Schritte aufweist:

Ausbilden einer ersten Isoliermaterialschicht (7) über einer Halbleitermaterialschicht (2) eines ersten Leitfähigkeitstyps;
Ausbilden einer ersten Schicht (8) aus leitendem Material über der ersten Isoliermaterialschicht (7);
Ausbilden einer zweiten Isoliermaterialschicht (9) über der ersten Schicht (8) aus leitendem Material;
durch Maskieren und Ätzen selektives Entfernen der zweiten Isoliermaterialschicht (9) und der ersten Schicht (8) aus leitendem Material, um eine Vielzahl von Fenstern (12) zu öffnen, die in einer Längsrichtung auf einer Oberfläche der Halbleiterschicht (2) ausgedehnt bzw. länglich sind, und um eine Vielzahl von Streifen parallel zu und abwechselnd zu den Fenstern (12) und durch sie begrenzt auszubilden, wobei die Streifen durch erste Teile der ersten Schicht (8) aus leitendem Material und zweite Teile der zweiten Isoliermaterialschicht (9) ausgebildet sind, die sich in einer Richtung transversal zu den Streifen erstrecken und eine gleiche Dimension entlang der transversalen Richtung haben;

Ausbilden eines Körperstreifens (3) eines zweiten Leitfähigkeitstyps, der entgegengesetzt zum ersten ist, in der Halbleitermaterialschicht (2) unter jedem länglichen Fenster (12), wobei in jedem Körperstreifen (3) ein zentraler stark dotierter tiefer Körperstreifen (17) und zwei laterale leicht dotierte Kanalstreifen (18) ausgebildet sind, wobei der zentrale stark dotierte tiefe Körperstreifen (17) mit den Rändern des länglichen Fensters (12) in der isolierenden Gate-Schicht (7, 8, 9) ausgerichtet ist, wobei die Spitzenkonzentration eines Dotierungsmittels des stark dotierten tiefen Körperstreifens unter den in einem späteren Schritt auszubildenden Source-Teilen (60; 61; 62) angeordnet ist;

Ausbilden einer Vielzahl von Source-Teilen (60; 61; 62) in dem Körperstreifen (3), die mit einem Dotierungsmittel des ersten Leitfähigkeitstyps dotiert sind, auf derartige Weise, um zwischen Körperteilen (40, 41; 3') des Körperstreifens (3) eingeschoben zu sein, in welchen keine Dotierungsmittel des ersten Leitfähigkeitstyps vorgesehen sind, wobei jeder Source-Teil (60; 61; 62) vollständig über einem jeweiligen Teil des zentralen stark dotierten tiefen Körperstreifens (17) angeordnet ist;

Ausbilden von Seitenwandabstandsstücken (13) aus Isoliermaterial entlang den Rändern jedes Fensters (12); und dann

Ausbilden einer zweiten Schicht (10) aus leitendem Material über der zweiten Isoliermaterialschicht (9), wobei die zweite Schicht (10) aus leitendem Material die Source-Teile (60; 61; 62) und den Körperteil (40; 41; 3') kontaktiert.

23. Herstellungsverfahren nach Anspruch 22, **dadurch gekennzeichnet, dass** der Schritt zum Ausbilden des Körperstreifens (3) für ein selektives Einführen eines Dotierungsmittels des zweiten Leitfähigkeitstyps in die Halbleitermaterialschicht (2) unter Verwendung der zweiten Isoliermaterialschicht (9) als Maske sorgt.

24. Herstellungsverfahren nach Anspruch 23, **dadurch gekennzeichnet, dass** der Schritt zum Ausbilden des Körperstreifens (3) sorgt für:

ein Durchführen einer Implantierung eines Dotierungsmittels des zweiten Leitfähigkeitstyps mit einer vorgeschriebenen hohen Energie und in einer starken Dosis unter Verwendung der zweiten Isoliermaterialschicht (9) als Maske, wobei die Energie ausreichend ist, um eine Spitzenkonzentration des Dotierungsmittels bei einem vorgeschriebenen Abstand von der Oberfläche der Halbleitermaterialschicht (2) unter den Source-Teilen (60; 61; 62) zu anzuordnen;

ein Durchführen einer thermischen Diffusion des implantierten Dotierungsmittels mit einer vorgeschriebenen Wärmebilanz, so dass der Körperstreifen (3) den zentralen stark dotierten tiefen Körperstreifen (17) und die zwei lateralen leicht dotierten Kanalstreifen (18) aufweist.

25. Herstellungsverfahren nach Anspruch 24, **dadurch gekennzeichnet, dass** der Schritt zum Ausbilden des Körperstreifens (3) sorgt für:

ein Durchführen einer ersten Implantierung eines Dotierungsmittels des zweiten Leitfähigkeitstyps unter Verwendung der zweiten Isoliermaterialschicht (9) als Maske mit einer Implantierungsenergie, die zum Anordnen der Spitzenkonzentration des Dotierungsmittels im Wesentlichen bei der Oberfläche der Halbleitermaterialschicht geeignet ist, wobei die Implantierungsdosis die Schwellenspannung der MOS-Leistungsvorrichtung bestimmt;

ein Durchführen einer zweiten Implantierung eines Dotierungsmittels des zweiten Leitfähigkeitstyps unter Verwendung der zweiten Isoliermaterialschicht (9) als Maske mit einer Implantierungsdosis, die wesentlich höher als diejenige der ersten Implantierung ist, wobei die Implantierungsenergie zum Anordnen der Spitzenkonzentration des Dotierungsmittels bei einem vorgeschriebenen Abstand von der Oberfläche der Halbleitermaterialschicht (2) unter den Source-Teilen (60; 61; 62) geeignet ist;

ein Durchführen eines thermischen Diffusionsprozesses.

26. Herstellungsverfahren nach Anspruch 22, **dadurch gekennzeichnet, dass** die erste Isoliermaterialschicht (7) eine Siliziumdioxidschicht ist, die erste Schicht (8) aus leitendem Material eine dotierte Polysiliziumschicht ist und die zweite Isoliermaterialschicht (9) eine Passivierungsschicht ist.

27. Herstellungsverfahren nach Anspruch 23, **dadurch gekennzeichnet, dass** der Schritt zum selektiven Entfernen der zweiten Isoliermaterialschicht (9) und der ersten Schicht (8) aus leitendem Material mittels einer einzigen Fotolithografie durchgeführt wird, wobei das längliche Fenster (12) eine Dimension (Lp) entlang der transversalen Richtung im Wesentlichen gleich zu der optischen Auflösungsgrenze (f) der Fotolithografievorrichtung hat, die zum Durchführen der Fotolithografie verwendet wird.

28. Herstellungsverfahren nach Anspruch 22, **dadurch gekennzeichnet, dass** die erste Schicht (8) aus leitendem Material eine dotierte Polysiliziumschicht und eine Silizidschicht aufweist.

29. Herstellungsverfahren nach Anspruch 28, **dadurch gekennzeichnet, dass** die Silizidschicht eine Kobaltsilizidschicht ist.

30. Herstellungsverfahren nach Anspruch 22, **dadurch gekennzeichnet, dass** es für ein Ausbilden einer Vielzahl der länglichen Fenster (12) im Wesentlichen parallel zueinander und für ein Ausbilden einer jeweiligen Vielzahl von Körperstreifen (3) des zweiten Leitfähigkeitstyps in der Halbleitermaterialschicht (2) sorgt.

31. Herstellungsverfahren nach einem der Ansprüche 22 bis 30, **dadurch gekennzeichnet, dass** die Halbleitermaterialschicht (2) eine leicht dotierte Schicht ist, die über einem stark dotierten Halbleitersubstrat (1) epitaxial aufgewachsen ist.

32. Herstellungsverfahren nach Anspruch 31, **dadurch gekennzeichnet, dass** das Halbleitersubstrat (1) vom ersten Leitfähigkeitstyp ist.

33. Herstellungsverfahren nach Anspruch 31, **dadurch gekennzeichnet, dass** das Halbleitersubstrat vom zweiten Leitfähigkeitstyp ist.

EP 0 772 242 B1

## Fig.1

PRIOR ART

Fig.2

Fig.3

Fig.4

Fig.5

Fig.6

Fig.7

Fig.8

Fig.9

Fig.10

Fig.11

Fig.12

Fig.13

Fig.14

**Fig.15**

**Fig.16**

**Fig.17**

Fig.18

Fig.19

Fig.20

Fig.21

Fig.22

EP 0 772 242 B1

Fig.23

Fig.24

Fig.25

## Fig.26

Fig.27

Fig.28

<u>Fig.29</u>